(19) Europäisches Patentamt
European Patent Office
Office européen des brevets

(11) Veröffentlichungsnummer: **0 167 020**
**B1**

(12) **EUROPÄISCHE PATENTSCHRIFT**

(45) Veröffentlichungstag der Patentschrift: **23.11.88**

(51) Int. Cl.⁴: **H 05 K 1/03**, H 05 K 3/02, C 09 D 3/48, B 05 D 7/16

(21) Anmeldenummer: **85107109.2**

(22) Anmeldetag: **10.06.85**

(54) **Flexible Polyimid-Mehrschichtlaminate.**

(30) Priorität: **30.06.84 DE 3424232**
**25.02.85 DE 3506525**

(43) Veröffentlichungstag der Anmeldung:
**08.01.86 Patentblatt 86/2**

(45) Bekanntmachung des Hinweises auf die Patenterteilung:
**23.11.88 Patentblatt 88/47**

(84) Benannte Vertragsstaaten:
**AT BE CH DE FR GB IT LI LU NL SE**

(56) Entgegenhaltungen:
**EP-A-0 048 221**
**EP-A-0 116 297**
**DE-A-3 215 944**
**US-A-3 179 634**

(73) Patentinhaber: **Akzo Patente GmbH, Postfach 10 01 49 Kasinostrasse 19- 23, D-5600 Wuppertal- 1 (DE)**

(72) Erfinder: **Kundinger, Ernst F., Dipl.- Chem., Odenwaldring 28, D-6127 Breuberg/Neustadt (DE)**
Erfinder: **Klimesch, Erich, Berlinder Strasse 11, D-8565 Erlenbach (DE)**
Erfinder: **Zengel, Hans G., Dr. Dipl.- Ing., Nordring 6, D-8751 Kleinwallstadt (DE)**
Erfinder: **Lasher, Jeffery D., 20 Alfred Drive, Tolland Connecticut 060084 (US)**



Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

## Beschreibung

Die Erfindung betrifft flexible Mehrschichtlaminate bestehend aus mindestens einer Schicht aus einem nicht mehr formbaren vollaromatischen Polyimid und mindestens einer Schicht aus einem Trägermaterial. Sie betrifft ebenfalls ein Verfahren zur Herstellung dieser Laminate.

Laminate, die eine oder mehrere Schichten aus Polyimid und eine oder mehrere Schichten aus Trägermaterial enthalten, lassen sich vielseitig verwenden, so z. B. als Verstärkungsmaterialien. Daneben werden solche Laminate in Form mit Polyimid beschichteter Metallfolien für gedruckte elektrische Schaltungen eingesetzt. Hierbei macht man von der Flexibilität sowie den hervorragenden mechanischen, thermischen und elektrischen Eigenschaften der Polyimide Gebrauch. Die Laminate werden nämlich bei der Weiterverarbeitung, z. B. beim Löten oder Bohren häufig hohen Temperaturen ausgesetzt. An die Laminate werden auch hohe Anforderungen bezüglich der elektrischen und mechanischen Eigenschaften gestellt. Laminate, welche nur eine Trägerschicht aus Metall oder einer Metallegierung und eine Schicht aus Polyimid enthalten, sogenannte single clads, können für gedruckte elektrische Schaltungen ebenso verwendet werden wie Mehrschichtlaminate wie z. B. sogenannte double clads oder Mehrschicht-Schaltkreise, die mehrere Metallschichten und/oder mehrere Polyimidschichten aufweisen. In bestimmten Fällen jedoch sind Mehrschichtlaminate den single clads überlegen. So ist es z. B. bei gedruckten elektrischen Schaltungen häufig nötig, Schaltbahnen zu legen, die einander überkreuzen. Bei Verwendung von single clads lassen sich die oft gewünschten hohen Packungsdichten nicht erzielen, sondern nur bei Verwendung von Mehrschichtlaminaten, also z. B. von double clads. Gegenstand der vorliegenden Erfindung sind Mehrschichtlaminate, die sich ausgezeichnet für die Herstellung von double clads und Mehrfach-clads eignen. Unter double clads sind hierbei Laminate zu verstehen, welche zwei (metallische) Trägerschichten enthalten, und unter Mehrfach-clads solche, welche mehr als zwei (metallische) Trägerschichten enthalten.

Laminate, welche Polyimide und Trägermaterialien enthalten, sind bekannt. Hierbei sind vielfach die Polyimidschichten über einen herkömmlichen Klebstoff an die Trägermaterialien gebunden. So beschreibt z. B. die US-PS-3 900 662 die Verbindung von Polyimid mit Metall über eine Klebschicht auf Acrylatbasis. Auch in dem in der US-PS-3 822 175 beschriebenen Gegenstand wird von dieser Möglichkeit Gebrauch gemacht. Es hat sich jedoch gezeigt, daß bei Verwendung herkömmlicher Klebstoffe z. B. auf Basis Acrylat, Epoxid, Polyamid, Phenolharz usw. die Laminate, in denen das Polyimid über eine verklebende Zwischenschicht aus einem dieser Klebstoffe an das Metall gebunden ist, keine voll befriedigenden Eigenschaften aufweisen, die den vielfach gestellten hohen Anforderungen genügen. Dies liegt einerseits daran, daß die thermische Stabilität der Klebeschicht der des Polyimids unterlegen ist. So kann die Klebeschicht einen ernstlichen Nachteil bei der Weiterverarbeitung der Laminate bilden, da bei den hierbei angewandten hohen Temperaturen die Klebstoffe fließfähig werden und so die Qualität des Produkts beeinträchtigen können. Die Klebstoffe sind daneben den Polyimiden bezüglich ihrer elektrischen Eigenschaften, d.h. ihrer isolierenden Wirkung unterlegen.

Wegen der Nachteile der Laminate, die Klebeschichten aus herkömmlichen Klebstoffen zwischen Polyimid und Metall enthalten, wurden Mehrschichtlaminate vorgeschlagen, in denen das Polyimid direkt, also ohne verklebende Zwischenschicht, an Metall gebunden ist. So beschreibt z. B. die DE-OS-3 215 944 Laminate, in denen zwei Metallschichten über eine Zwischenschicht aus Polyimid verbunden sind. Das hierbei verwendete Polyimid ist zum überwiegenden Teil auf Basis von Diphenyltetracarbonsäure aufgebaut und läßt sich bei Anwendung von hohem Druck und hoher Temperatur mit einer Metallfolie verbinden. Es handelt sich hierbei also um ein formbares Polyimid. Nun hat sich jedoch gezeigt, daß formbare Polyimide oder Polyimide, welche in phenolischen Lösungsmitteln löslich sind, in ihrer thermischen Stabilität den nicht mehr formbaren, vollaromatischen, in phenolischen Lösungsmitteln unlöslichen Polyimiden unterlegen sind.

Es wurden wegen der Nachteile von Klebstoffen bereits single clads aus einem Trägermaterial, an das ein nicht mehr formbares, vollaromatisches, in phenolischen Lösungsmitteln unlösliches Polyimid direkt gebunden ist, vorgeschlagen. Diese single clads weisen hervorragende mechanische thermische und elektrische Eigenschaften auf.

Ausgehend von diesen single clads wären Mehrfachlaminate wünschenswert, die ebenfalls nur aus Trägermaterialien und diesen nicht mehr formbaren, vollaromatischen Polyimiden bestehen und die somit die gleichen mechanischen, thermischen und elektrischen Eigenschaften besitzen. Es hat sich jedoch gezeigt, daß es nicht möglich ist, zwei oder mehrere single clads dieser Art direkt miteinander zu verbinden oder ein solches single clad direkt, d.h. ohne verklebende Zwischenschicht, mit einem metallischen Trägermaterial zu verbinden, da auf die vollständig ausgehärtete Polyimidschicht keine weitere Schicht aus Trägermaterial oder kein weiteres single clad ohne Zwischenschicht so aufgebracht werden kann, daß eine hohe Schälfestigkeit resultiert, d.h. eine hohe Haftung zwischen Polyimid und der zusätzlich aufgebrachten Schicht. Andererseits ist zwar das Aufbringen der weiteren Schicht aus Trägermaterial vor vollständiger Aushärtung des Polyimids prinzipiell möglich und führt zu einer Erhöhung der Schälfestigkeit. Es kann jedoch hierbei zu Blasenbildung in der Polyimidschicht kommen, da bei deren Aushärtung flüchtige Bestandteile, z. B. Wasser, entweichen müssen und das Freisetzen dieser flüchtigen Bestandteile durch die zusätzliche Schicht aus Trägermaterial gestört werden kann.

Die europäische Patentanmeldung EP-A-0 116 297, welche eine Druckschrift nach Art 54(3) EPÜ darstellt, beschreibt Laminate aus einem nicht mehr formbaren, vollaromatischen Polyimid und einem direkt damit verbundenen Trägermaterial. Diese Laminate zeichnen sich durch gute Haftung zwischen Polyimid und Trägermaterial sowie durch gute mechanische und elektrische Eigenschaften aus. Mehrfachlaminate aus nicht

mehr formbarem Polyimid, Trägermaterial und einer Schicht aus formbarem (heißsiegelbarem) Polyimid werden in dieser Patentanmeldung nicht beschrieben.

Der vorliegenden Erfindung lag somit die Aufgabe zu Grunde, Mehrschichtlaminate aus Polyimiden und Trägermaterialien zur Verfügung zu stellen aus denen double clads oder Mehrfachclads mit hervorragenden thermischen, elektrischen und mechanischen Eigenschaften hergestellt werden können, bei denen die Vorteile einer direkten Verbindung zwischen Trägermaterial und nicht mehr formbarem, vollaromatischem Polyimid genutzt, und die Nachteile bekannter Mehrschichtlaminate vermieden werden.

Die Aufgabe wird gelöst durch flexible Mehrschicht-Laminate, bestehend aus mindestens einer Schicht aus einem Trägermaterial und mindestens einer Schicht aus einem vollaromatischen, nicht mehr formbaren Polyimid, wobei mindestens eine Schicht aus nicht mehr formbarem Polyimid an einer Seite direkt an einer Schicht aus Trägermaterial mit einer Schälfestigkeit von mindestens 4,0 N/cm haftet, wobei dieses nicht mehr formbare Polyimid in phenolischen Lösungsmitteln unlöslich ist und diese Schicht aus nicht mehr formbarem Polyimid eine Zugfestigkeit von 100 bis 150 $N/mm^2$, eine Bruchdehnung von 15 - 100 % und einen dielektrischen Verlustfaktor von 1,5 x $10^{-3}$ bis 5 x $10^{-3}$ bei 1 kHz aufweist, und wobei sich auf der dem Trägermaterial abgewandten Seite dieser Schicht aus nicht mehr formbarem Polyimid eine Schicht aus einem heißsiegelbaren Polyimid befindet, wobei dieses heißsiegelbare Polyimid nicht unterhalb von 200° C schmilzt und bei einer Temperatur im Bereich zwischen 150° C und 500° C, ggf. durch Anwendung eines Drucks, formbar ist.

Die erfindungsgemäßen Laminate enthalten somit mindestens eine Schicht aus nicht mehr formbarem Polyimid, die an einer ihrer beiden Seiten direkt, d.h. ohne eine Zwischenschicht, an einer Schicht aus Trägermaterial haftet. Die Schälfestigkeit des Gebildes aus nicht mehr formbarem Polyimid und Trägermaterial, gemessen nach der in IPC TM 650, 2.4.9 angegebenen Methode, beträgt mindestens 4,0 N/cm. Auf der anderen Seite bzw. Oberfläche der Schicht aus nicht mehr formbarem Polyimid befindet sich eine Schicht aus einem heißsiegelbaren Polyimid. Die erfindungsgemäßen Laminate enthalten somit mindestens ein Element, das den Grundkörper dieser Laminate darstellt und folgendermaßen aufgebaut ist: Trägermaterial/nicht mehr formbares Polyimid/heißsiegelbares Polyimid. Die Schicht aus nicht mehr formbarem Polyimid besitzt eine Zugfestigkeit von 100 bis 150 $N/mm^2$, gemessen nach ASTM D 882, eine Bruchdehnung von 15 bis 100 %, gemessen nach ASTM D 882 sowie einen dielektrischen Verlustfaktor von 1,5 x $10^{-3}$ bis 5 x $10^{-3}$ bei 1 kHz, gemessen nach ASTM D-150.

Unter "nicht mehr formbaren, vollaromatischen, in phenolischen Lösungsmitteln unlöslichen Polyimiden" werden hierbei Polyimide verstanden, die aus aromatischen Tetracarbonsäuren bzw. deren Dianhydriden und aus primären aromatischen Diaminen erhalten werden, wobei die Carboxyl- bzw. die primären Aminogruppen direkt an einen aromatischen Ring gebunden sind. Es ist jedoch nicht erforderlich, daß die nicht mehr formbaren vollaromatischen Polyimide in jedem Fall aus genau diesen Verbindungen hergestellt werden, da Polyimide mit identischen Strukturen und Eigenschaften auch aus anderen Ausgangsverbindungen hergestellt werden können, z. B. durch Umsetzung der genannten Dianhydride mit geeigneten aromatischen Diisocyanaten. Diese Polyimide sind nicht unzersetzt schmelzbar und in herkömmlichen Lösungsmitteln, also auch in phenolischen Lösungsmitteln wie Phenol, Kresolen und halogenierten Phenolen, unlöslich. Es ist also bei diesen Polyimiden weder über Schmelzen noch über Lösen eine neue Formgebung möglich.

Aus den erfindungsgemäßen Laminaten, welche den Grundkörper Trägermaterial/nicht mehr formbares Polyimid/heißsiegelbares Polyimid enthalten, lassen sich in vorteilhafter Weise double clads und Mehrschicht-Schaltkreise herstellen. So lassen sich u.a. folgende Produkte mit hervorragenden elektrischen, mechanischen chemischen und thermischen Eigenschaften ausgehend von diesen Laminaten erhalten:

a) double clads mit dem Aufbau:

Trägermaterial/nicht mehr formbares Polyimid/heißsiegelbares Polyimid/nicht mehr formbares Polyimid/Trägermaterial

b) double clads mit dem Aufbau:

Trägermaterial/nicht mehr formbares Polyimid/heißsiegelbares Polyimid/heißsiegelbares Polyimid/nicht mehr formbares Polyimid/Trägermaterial

c) double clads mit dem Aufbau:

Trägermaterial/nicht mehr formbares Polyimid/heißsiegelbares Polyimid/Trägermaterial

d) Mehrfachclads, bei denen die außenliegende Oberfläche einer oder beider Trägermaterialschicht(en) der unter a) bis c) genannten Laminate direkt mit nicht mehr formbarem Polyimid verbunden ist. Auch die außenliegende Oberfläche der Trägermaterialschicht des Grundkörpers (mit dem Aufbau: Trägermaterial/nicht nehr formbares Polyimid/heißsiegelbares Polyimid) kann mit einer Schicht aus nicht mehr formbarem Polyimid direkt verbunden sein. Diese Produkte sind also dadurch gekennzeichnet, daß sie mindestens eine Schicht aus Trägermaterial enthalten, die auf beiden Seiten mit je einer Schicht aus nicht mehr formbarem Polyimid verbunden ist.

Die unter a) bis d) beschriebenen Laminate stellen bevorzugte Ausführungsformen der erfindungsgemäßen Laminate dar. Ihre Herstellung wird weiter unten beschrieben.

Die Produkte a) und b) unterscheiden sich dadurch, daß in einem Fall nur eine Schicht aus heißsiegelbarem Polyimid vorliegt, im anderen zwei Schichten, die jedoch mehr oder weniger ineinander übergehen können. Bei den unter a) und b) genannten Produkten können sowohl die beiden Schichten aus nicht mehr formbarem Polyimid als auch die beiden Schichten aus Trägermaterial jeweils gleiche oder voneinander verschiedene chemische Struktur und/oder Schichtdicke aufweisen. Für die unter b) genannten Produkte gilt dies zusätzlich

für die beiden Schichten aus heißsiegelbarem Polyimid.

Bei den unter a) und b) genannten Produkten sind somit zwei Schichten aus nicht mehr formbaren Polyimiden (die beide direkt an je einer Seite mit Trägermaterial verbunden sind) jeweils auf der dem Trägermaterial abgewandten Seite mittels heißsiegelbarem Polyimid miteinander verbunden. Sie enthalten alle den Grundkörper der erfindungsgemäßen Laminate. Das Zusammenfügen zweier solcher (gleicher oder verschiedener) Grundkörper jeweils an der Schicht aus heißsiegelbarem Polyimid führt zu den unter b) genannten Produkten. Die unter a) genannten Produkte entstehen z. B. dann, wenn zwei der Grundkörper so miteinander verbunden sind, daß die beiden ursprünglich getrennten Schichten aus heißsiegelbarem Polyimid ineinander übergehen und im fertigen Produkt nur noch eine einzige definierte Schicht bilden.

Bei den unter c) genannten Produkten befindet sich auf der Schicht aus heißsiegelbarem Polyimid des Grundkörpers eine Schicht aus Trägermaterial. Wenn als Trägermaterial eine Metallfolie verwendet wird, können diese double clads für gedruckte elektrische Schaltkreise verwendet werden.

Unter die unter c) genannten Produkte fallen jedoch auch solche, die sich ergeben, wenn man den Grundkörper der erfindungsgemäßen Laminate (Trägermaterial/nicht mehr formbares Polyimid/heißsiegelbares Polyimid) als sogenanntes "end cap" einsetzt. Hierbei ist der Grundkörper an seiner freiliegenden Schicht aus heißsiegelbarem Polyimid mit der Metallschicht einer fertigen gedruckten Schaltung verbunden. Diese fertige gedruckte Schaltung stellt also in diesem Fall dasjenige Trägermaterial dar, das mit heißsiegelbarem Polyimid gemäß dem unter c) genannten Aufbau verbunden ist.

Der Grundkörper der erfindungsgemäßen Laminate sowie die unter a) bis d) genannten Ausführungsformen enthalten somit außer Trägermaterial nur Polyimide, die, wie erwähnt, anderen Materialien wie herkömmlichen Klebstoffen bezüglich ihrer thermischen, mechanischen, chemischen und elektrischen Eigenschaften überlegen sind. Somit eignen sich diese Laminate in hervorragender Weise für die Herstellung gedruckter elektrischer Schaltungen. Das heißsiegelbare Polyimid, das, wie unten beschrieben, bei höheren Temperaturen formbar ist, weist zwar höhere Temperaturstabilität auf als herkömmliche Klebstoffe z. B. auf Acrylatbasis, Phenolharzbasis usw., erreicht jedoch naturgemäß nicht die thermische Stabilität des nicht mehr formbaren Polyimids, was vollständige Beibehaltung der Form auch bei hohen Temperaturen betrifft. Da bei Verwendung der erfindungsgemäßen Laminate für gedruckte elektrische Schaltungen als Trägermaterialien Metalle oder Legierungen verwendet und bei Weiterverarbeitung der Laminate hohe Temperaturen angewandt werden, besteht somit ein Vorteil des Grundkörpers der erfindungsgemäßen Laminate darin, daß das heißsiegelbare Polyimid nicht mit Metall, sondern mit dem nicht mehr formbaren Polyimid verbunden ist. Auf diese Weise wird das thermisch, d.h. bezüglich Beibehaltung der Form, etwas weniger stabile heißsiegelbare Polyimid durch das stabilere Polyimid geschützt, da die hohen Temperaturen an der Metallschicht, z. B. beim Löten, vorliegen. Dadurch, daß in dem Grundkörper der erfindungsgemäßen Laminate sowie in den oben unter a) bis d) beschriebenen Produkten jeweils Schichten aus Trägermaterial, z. B. Metall, vorliegen, die an einer oder beiden Seiten direkt mit nicht mehr formbarem Polyimid verbunden sind, ist die Anzahl der erforderlichen Klebeschichten auf ein Minimum reduziert. Dies ist deshalb von großer Bedeutung, weil dadurch die thermische Stabilität der Produkte erhöht sowie ihre Gesamtschichtdicke erniedrigt werden kann. Dort, wo Klebeschichten unerläßlich sind, bestehen sie aus heißsiegelbarem Polyimid, das anderen Klebstoffen bezüglich seiner thermischen Stabilität überlegen ist. Es ist, wie oben erwähnt vorteilhaft, wenn eine oder beide Schicht(en) aus Trägermaterial auf jeweils beiden Seiten mit einer Schicht aus nicht mehr formbarem, vollaromatischem Polyimid verbunden ist bzw. sind. Auf diese Weise kann man zu Vielfach-clads gelangen, die auch bei gedruckten elektrischen Schaltungen komplexen Aufbaus hohe Packungsdichte ermöglichen.

Es können in diesem Fall auf einer oder beiden außenliegenden Oberfläche(n), die nunmehr aus nicht mehr formbarem Polyimid besteht bzw. bestehen, auch weitere Schichten angebracht sein, unter denen sich auch andere Materialien als Polyimide befinden können, wenn der vorgesehene Verwendungszweck dies gestattet.

Als nicht mehr formbare, vollaromatische Polyimide werden bevorzugt Verbindungen verwendet, welche die in den Ansprüchen 13 und 14 angegebenen Struktureinheiten aufweisen. Diese Polyimide können durch Umsetzung von Tetracarbonsäuren oder deren Mono- oder Dianhydriden mit Diaminen erhalten werden. Beispiele für geeignete Dianhydride sind Pyromellitsäuredianhydrid, 2,3,6,7-Naphthalintetracarbonsäuredianhydrid, 3,4,3',4'-Diphenylsulfon-tetracarbonsäuredianhydrid, Perylen-3,4,9,10-tetracarbonsäuredianhydrid, 3,4,3',4'-Diphenyläther-tetracarbonsäuredianhydrid.

Beispiele für Diamine, die mit den Tetracarbonsäuren bzw. deren Derivaten zu geeigneten nicht mehr formbaren, vollaromatischen Polyimiden umgesetzt werden können, sind: 4,4'-Diamino-diphenyläther; 5-Amino-2-(p-aminophenyl)-benzothiazol; 4-Amino-2-(p-aminophenyl)-benzothiazol: 5-Amino-2-(m-aminophenyl)-benzothiazol; 5-Amino-2-(p-aminophenyl)-benzoxazol; 4-Amino-2-(m-aminophenyl)-benzothiazol; p- und m-Phenylendiamin; 4,4'-Diamino-diphenyl; Bis-(4-aminopheuyl)-Methan; 4-Amino-2-(p-aminophenyl)-benzoxazol; 4-Amino-2-(m-aminophenyl)-benzoxazol; 5-Amino-2-(m-aminophenyl)-benzoxazol: 2,5-Diaminobenzoxazol: 2,5-Diamino-benzothiazol.

Als besonders geeignet hat sich das durch Umsetzung von Pyromellitsäuredianhydrid (PMDA) mit 4,4'-Diaminodiphenyläther (DADE) erhältliche Polyimid erwiesen.

Unter heißsiegelbaren Polyimiden im Sinne der Erfindung werden Polyimide verstanden, welche bei einer Temperatur tm Bereich zwischen 150°C und 500°C formbar sind, z. B. durch Anwendung eines Drucks, und welche nicht unterhalb von 200°C schmelzen. Es ist jedoch nicht erforderlich, daß diese Polyimide überhaupt einen definierten Schmelzpunkt oder -bereich aufweisen. Es genügt, wenn sie, ohne zu schmelzen, einer Formgebung im angegebenen Temperaturbereich zugänglich sind. Diese Eigenschaft unterscheidet sie von der

anderen Art von Polyimiden, welche in den erfindungsgemäßen Laminaten vorliegen. Die Forderung, daß die heißsiegelfähigen Polyimide bei einer Temperatur im Bereich zwischen 150° C und 500° C formbar sein müssen, bedeutet natürlich nicht, daß alle Polyimide, welche diese Forderung erfüllen, für alle Verwendungszwecke der erfindungsgemäßen Laminate geeignet sind. Vielmehr kann es erforderlich sein, daß für einen bestimmten Verwendungszweck nur Polyimide verwendet werden, welche erst ab 250°C oder höher eine Formbarkeit aufweisen.

Besonders bevorzugte Beispiele für heißsiegelbare Polyimide sind solche, die durch Umsetzung von Benzophenon-tetracarbonsäuredianhydrid (BTDA) oder einem Gemisch dieses Dianhydrids und Pyromellitsäuredianhydrid mit 4,4'-Diaminodiphenyläther, 3,3'-Diaminodiphenyläther, 3,3'-Diaminodiphenylsulfon, 3,3'-Diaminodiphenylmethan, 4,4'-Diaminodiphenylsulfon (DDS), 4,4'-Diaminodiphenylmethan (DDM), Benzidin oder mit Gemischen dieser Diamine erhalten werden. Es können hierbei Gemische eingesetzt werden, die zwei oder mehr der genannten Diamine enthalten. Das Benzophenon-tetracarbonsäuredianhydrid kann das 2,3,2',3'- oder das 3,4,3',4'- oder das 2,3,3',4'-Isomere oder ein Gemisch aus diesen Isomeren sein. Daneben haben sich heißsiegelbare Polyimide als gut geeignet erwiesen, die dadurch gekennzeichnet sind, daß das heißsiegelbare Polyimid das Reaktionsgemisch eines Dianhydrids mit einem Diamin ist, wobei das Dianhydrid die Formel

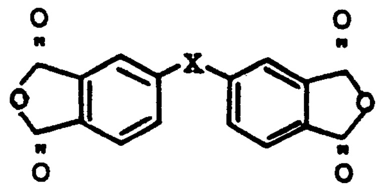

aufweist, worin X für ein Sauerstoffatom steht oder für eine $C_nF_{2n}$-Gruppe mit n = 1 bis 10 oder für die Gruppierung

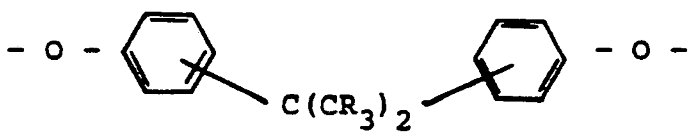

steht, in der R ein Wasserstoffatom oder ein Fluoratom bedeutet und in der die $(CR_3)_2$-Gruppe sich jeweils in meta- oder para-Stellung zum betreffenden Sauerstoffatom befindet und wobei das Diamin die Formel

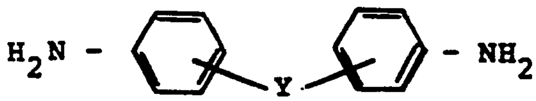

oder die Formel

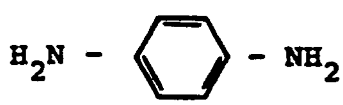

aufweist, wobei Y für ein Sauerstoffatom steht oder für eine $C_nF_{2n}$-Gruppe mit n = 1 bis 10 oder für eine Carbonylgruppe und wobei sich Y jeweils in meta- oder para-Stellung zur betreffenden Aminogruppe befindet. Die $C_nF_{2n}$-Gruppe kann ein linearer oder verzweigter perfluorierter Alkylrest sein. Beispiele für weitere geeignete Dianhydride, die mit Diaminen zu heißsiegelbaren Polyimiden umgesetzt werden können, sind Verbindungen der o.a. Formel

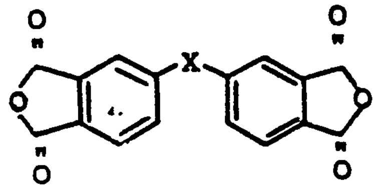

in denen X für

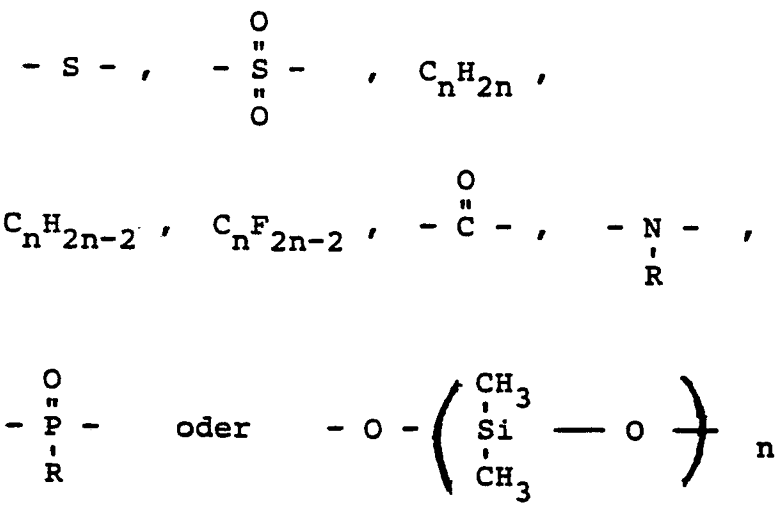

steht, wobei n die Werte 1 bis 10 annehmen kann und R einen linearen oder verzweigten Alkylrest, einen linearen oder verzweigten, ganz oder teilweise halogenierten Alkylrest, einen aromatischen oder heteroaromatischen Rest bedeutet.

Weitere Beispiele für geeignete Diamine, aus denen sich durch Umsetzung mit Dianhydriden heißsiegelbare Polyimide erhalten lassen, sind Diamine der allgemeinen Formel

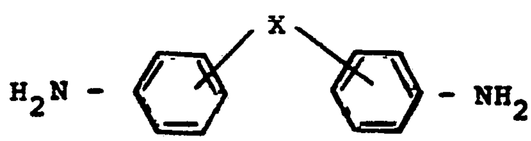

in denen X für die gleichen Gruppen steht wie oben angegeben.

Bei den genannten Diaminen können sich an einem oder beiden aromatischen Ringen ggf. einer oder mehrere weitere Substituenten befinden. Diese heißsiegelbaren Polyimide können natürlich auch aus anderen Ausgangsverbindungen hergestellt werden, z. B. durch Umsetzung der Tetracarbonsäuren, die diesen Dianhydriden zugrunde liegen, mit den genannten Diaminen. Eine Reihe dieser bekannten heißsiegelbaren Polyimide sind z. B. in der DE-PS-2 416 595, der DE-PS-2 441 101, der US-PS-3 264 250, in "Chemistry and Industry" (12.7.1969), S. 934) genannt.

Das Erfordernis der Heißsiegelbarkeit bzw. Formbarkeit der Polyimide ist nicht ausschließlich eine Frage der chemischen Natur der Ausgangsverbindungen, also des Dianhydrids und des Diamins. Vielmehr spielen auch die Herstellungsbedingungen, wie z. B. Temperatur oder Molverhältnis der Reaktionspartner, eine Rolle. Mit anderen Worten, es kann von der Wahl der Herstellungsbedingungen abhängen, ob aus den gleichen Ausgangsverbindungen entweder ein nicht mehr formbares oder ein formbares und damit heißsiegelfähiges Polyimid entsteht.

In einer bevorzugten Ausführungsform der erfindungsgemäßen Laminate weist nicht nur die aus dem nicht mehr formbaren Polyimid bestehende Schicht die in Anspruch 1 genannten Daten für die Zugfestigkeit, Bruchdehnung und dielektrischen Verlustfaktor auf, sondern auch der Schichtverbund, der aus einer oder zwei Schicht(en) von nicht mehr formbarem Polyimid und aus einer oder zwei Schicht(en) aus heißsiegelbarem Polyimid besteht. Diese Daten lassen sich, nachdem die Trägermaterialschicht(en) von dem Grundkörper der Laminate entfernt worden ist (sind), nach den oben genannten Standardmethoden bestimmen.

Eine sehr wirksame Verbindung von nicht mehr formbarem Polyimid mit heißsiegelbarem Polyimid besteht in einer bevorzugten Ausführungsform darin, daß diese Verbindung durch gegenseitiges Eindringen dieser

Materialien ineinander bewirkt ist. Es können hierbei so starke Verbindungskräfte auftreten, daß eine Trennung dieser Polyimide nicht mehr ohne Zerstörung der Schichten möglich ist. Darüber hinaus kann ein solches Eindringen ineinander auch von zwei Schichten aus heißsiegelbarem Polyimid, wie sie in den oben beschriebenen double clads vorliegen können, von Vorteil sein. Die Dicke der Schicht(en) aus nicht mehr formbarem Polyimid, welchen z. B. im Fall der Verwendung der Laminate für gedruckte elektrische Schaltungen die Funktion der Isolierung zufällt, kann in weiten Bereichen variiert werden. Die bevorzugten Verfahren zur Herstellung der erfindungsgemäßen Laminate, die unten beschrieben werden, gestatten nämlich auch die Erzeugung von Laminaten mit relativ dicken Schichten dieser Polyimide, die die hohen Anforderungen an diese Laminate erfüllen. Bevorzugt liegt die Dicke jeder Schicht aus nicht mehr formbarem Polyimid im Bereich zwischen 1 µm und 1 mm. Beim Einsatz der erfindungsgemäßen Laminate für übliche gedruckte Schaltkreise im Bereich der Elektronik haben sich Schichtdicken für die nicht mehr formbaren Polyimide von 10 µm bis 1 mm, insbesondere von 50 bis 250 µm als besonders geeignet erwiesen. Beim Einsatz der Laminate für gedruckte Schaltungen, die in Elektromotoren als Rotor und/oder Statorwicklungen verwendet werden, liegen die bevorzugten Schichtdicken dagegen niedriger, nämlich bei 1 µm bis 15 µm, weil in diesem Fall so platzsparend wie möglich gearbeitet werden sollte, um zu einer hohen Packungsdichte zu gelangen. In einer weiteren bevorzugten Ausführungsform sind alle diese Schichten aus nicht mehr formbarem Polyimid (sofern mehr als eine Schicht vorliegt) gleich dick. Dieser Fall tritt u.a. dann auf, wenn es sich um Mehrfachlaminate handelt, die aus identischen single clads einheitlicher Qualität hergestellt werden. Die Dicke der Schicht aus heißsiegelbarem Polyimid liegt für den oben erwähnten Fall des Einsatzgebietes Elektromotoren bevorzugt bei 0,5 bis 3 µm, im Fall des Einsatzes für übliche Schaltkreise im Bereich der Elektronik bei 2 bis 50 µm.

Eine bevorzugte Ausführungsform der Laminate besteht darin, daß die Schicht oder die Schichten aus Trägermaterial jeweils unabhängig voneinander aus einer Folie aus Metall oder einer Metallegierung oder aus einer Polymerfolie oder aus einem Flächengebilde aus einem Fasermaterial besteht bzw. bestehen.

Als Polymerfolien kommen hierbei beispielsweise Folien aus aromatischen Polyamiden oder Polyimiden in Betracht, als Fasermaterialien für die Flächengebilde Metallfasern, synthetische Fasern z. B. aus aromatischen Polyamiden, und mineralische Fasern wie Glasfasern, Quarzfasern, Asbestfasern oder Kohlenstoffasern.

Besonders bevorzugte Trägermaterialien, speziell im Hinblick auf die Verwendung der Laminate für gedruckte elektrische Schaltungen, sind Folien aus Kupfer, Nickel, Aluminium, oder Folien aus einer Legierung, welche eines oder mehrere dieser Metalle als wesentlichen Bestandteil enthält, wie z. B. einer Chrom/Nickel-Legierung. Auch Folien aus Stahl haben sich als sehr geeignet erwiesen. In einer speziellen Ausführungsform besteht das Trägermaterial aus einer Folie aus gewalztem, getempertem Kupfer oder einer gewalzten, getemperten Kupferlegierung. Daneben besteht eine bevorzugte Ausführungsform des erfindungsgemäßen Verfahrens darin, daß als Trägermaterial eine Folie aus amorphem Metall verwendet wird. Hierdurch lassen sich spezielle Eigenschaften der Laminate erzielen. Diese werden hervorgerufen durch die amorphen Metalle. Diese amorphen Metalle weisen nicht die bei Metallen üblichen Kristallstrukturen auf. Sie werden deshalb auch als "metallische Gläser" bezeichnet. Sie können hergestellt werden durch Abschrecken von Metallschmelzen oder von Schmelzen von Legierungen. Für die erfindungsgemäßen Laminate als Trägermaterial geeignete amorphe Metalle sind z. B. amorphe Legierungen, die Eisen enthalten. Weitere geeignete amorphe Metalle sind in dem Artikel in "Spektrum der Wissenschaft" Juni 1980, S. 46 beschrieben.

Die Schichtdicke der als Trägermaterial dienenden Folie(n) beträgt für den Fall, daß es sich um Metall- bzw. Legierungsfolien handelt, bevorzugt 5 bis 250 µm und in einer weiter bevorzugten Ausführungsform 10 bis 50 µm.

In einer vorteilhaften Ausführungsform der erfindungsgemäßen Laminate enthält die Schicht bzw. enthalten die Schichten aus heißsiegelbarem Polyimid ein Fasermaterial. Dieses dient der Verstärkung. Als Fasermaterialien kommen besonders temperaturstabile Glasfasern (Natrium-Aluminiumsilikatfasern), Aramidfasern (Fasern aus aromatischen Polyamiden), Kohlenstoffasern und/oder Kieselsäure ($SiO_2 \cdot nH_2O$)-fasern in Frage. Bevorzugt liegen diese Fasern als Gewebe aus Endlosfilamenten vor. Die Fasern können ggf. jedoch auch als Vlies oder als lose Stapelfasern eingesetzt werden.

Der Einsatz von Verstärkungsfasern ist natürlich nur oberhalb eines Mindestverhältnisses von Polyimidschichtdicke zu Faser- bzw. Gewebedurchmesser möglich bzw. sinnvoll.

Die erfindungsgemäßen Laminate lassen sich nach einem Verfahren herstellen, das gekennzeichnet ist durch die in Anspruch 27 angegebenen Maßnahmen.

Der erste Schritt des Verfahrens besteht somit in der Herstellung von single clads aus einem Trägermaterial und einem direkt mit dem Trägermaterial verbundenen, nicht mehr formbaren vollaromatischen Polyimid.

Dieser erste Verfahrensabschnitt wird nunmehr beschrieben.

Die Herstellung der Polyamidsäure erfolgt durch Umsetzung einer aromatischen Tetracarbonsäure, vorzugsweise Pyromellitsäure oder vorzugsweise ihres Dianhydrids, Pyromellitsäuredianhydrid (PMDA) mit einem primären aromatischen Diamin, bevorzugt ist 4,4'-Diaminodiphenyläther (DADE), in einem Lösungsmittel, zum Beispiel Dimethylacetamid (DMAc). Zum single clad gelangt man durch Aufbringen eines Films der Polyamidsäurelösung auf ein Trägermaterial, wie eine Metallfolie oder ein Polymermaterial oder ein Flächengebilde aus Fasermaterial und Aushärtung des Films in situ durch Hitzebehandlung in mindestens zwei Stufen, so daß man ein single clad erhält, dessen Polyimidschicht fest an dem genannten Trägermaterial haftet, ohne daß für die Verbindung der Polyimidfolie mit dem Substrat der Einsatz einer verklebenden Zwischenschicht erforderlich ist.

Bei dem single clad kann es sich um ein Flächengebilde, das heißt eine flexible Polyimidschicht handeln, die

an einer Folie aus Kupfer oder einem anderen metallischen Material, zum Beispiel Aluminium, Nickel oder Stahl oder einer Legierung, welche eines oder mehrere der genannten Metalle als wesentlichen Bestandteil enthält oder an einer Folie aus amorphem Metall haftet. In jedem Fall haftet die Polyimidschicht fest an dem Substrat und besitzt eine hohe Schälfestigkeit von 4,0 N/cm und mehr.

Als Trägermaterial können z. B. Werkstoffe aus metallischem Material oder aus synthetischen Polymeren dienen. Im Fall metallischer Werkstoffe muß es sich nicht um das Metall als Element in reiner Form handeln. Es können insbesondere auch Trägermaterialien aus Metallegierungen eingesetzt werden wie Legierungen, die Nickel, Chrom und Eisen oder Nickel und Kupfer enthalten oder amorphe Legierungen, die Eisen enthalten. Als besonders geeignete Trägermaterialien haben sich Folien aus gewalztem getempertem Kupfer oder aus einer gewalzten getemperten Kupferlegierung erwiesen. In manchen Fällen hat es sich als vorteilhaft erwiesen, das Trägermaterial vor der Beschichtung vorzubehandeln. Diese Vorbehandlung kann in einer chemischen Behandlung, z. B. Einwirkung einer sauren Salzlösung oder in einer mechanischen Aufrauhung bestehen. Es hat sich herausgestellt, daß sich durch diese Vorbehandlung eine weitere Erhöhung der Haftung der Polyimidschicht und damit eine Erhöhung der Schälfestigkeit erzielen läßt. Die chemische Vorbehandlung kann neben einer Aufrauhung der Oberfläche zur Ausbildung von Metalloxidgruppen an der zu beschichtenden Oberfläche des Trägermaterials führen, wodurch ggf. die Haftung eines metallischen Trägermaterials an der Polyimidschicht weiter erhöht werden kann. Als günstig hat es sich erwiesen, die Vorbehandlung so durchzuführen, daß ein Mittenrauhwert ($R_a$) von mindestens 0,2 µm erhalten wird.

Um zu den single clads zu gelangen, setzt man ein primäres aromatisches Diamin mit einer aromatischen Tetracarbonsäure oder ihrem Dianhydrid unter Bedingungen, die zur Bildung einer Lösung von Polyamidsäure in einem Lösungsmittel führen, um, in einer Ausführungsform der Erfindung in einem Extruder. Anschließend kann die Extrusion einer Schicht der Polyamidsäurelösung direkt auf das Substrat erfolgen, wobei, anschließend das Lösungsmittel in situ zunächst in einer ersten Heizzone weitgehend aus der Polyamidsäureschicht entfernt und die Polyamidsäureschicht dann in situ durch eime weitere Hitzebehandlung in mindestens einer zweiten Heizzone bei einer höheren, zu praktisch vollständiger Imidisierung führenden Temperatur ausgehärtet wird. Anstatt dis Polyamidsäurelösung durch Extrudieren auf das Trägermaterial aufzubringen, kann sie auch durch Aufrakeln aufgebracht werden. Die anschließende Temperaturbehandlung, die zur Entfernung des Lösungsmittels und zur Bildung des Polyimids führt, ist die gleiche wie oben angegeben. Eine Polyimidschicht von mehr als 10 µm zu erhalten, die keine Unterbrechungenn oder Fehler aufgrund von Blasen enthält, die hervorgerufen sind durch Zusammenwirken eines Hauteffektes und einer zu raschen Verdampfung des Lösungsmittsls oder des bei der Imidisierung oder Aushärtung entstehenden Wasserdampfes und die fest an dem Substrat haftet, gelingt durch eine besondere Folge von Hitzebehandlungen.

Die bei der Erfindung verwendeten, durch Umsetzung einer aromatischen Tetracarbonsäure oder ihres Dianhydrids mit einem primären aromatischen Diamin in einer polaren organischen Lösungsmittel erhaltenen Polyamidsäurevorprodukte besitzen folgende Strukturformel:

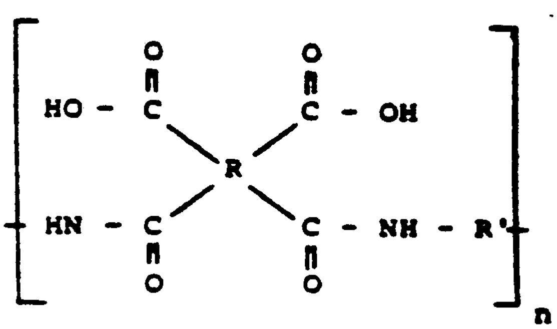

wobei

R einen aromatischen vierwertigen Rest und

R' einen zweiwertigen aromatischen Rest darstellen und

n ausreicht zur Bildung einer Polyamidsäure mit einer reduzierten Viskosität von 0,5 oder höher, gemessen als 0,5-%-ige Lösung in 0,1 Mol/Liter Lithiumbromid enthaltendem Dimethylacetamid.

Die Polyamidsäure wird nach dem Aufbringen auf das Substrat nach dem offenbarten Erhitzungsverfahren ausgehärtet, wobei ein nicht mehr formbares, in Phenol bzw. phenolartigen Lösungsmitteln unlösliches Polyimid mit der folgenden sich wiederholenden Struktur entsteht:

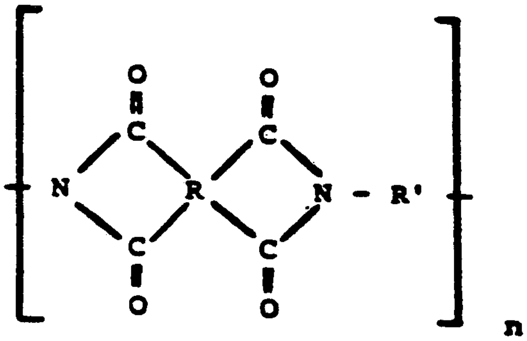

in der R und R' gleiche Reste darstellen, wie sie zuvor beschrieben worden sind.

Bei der Herstellung der Polyamidsäure werden als Auagangsmaterialien vorzugsweise Pyromellitsäuredianhydrid und 4,4'-Diaminodiphenyläther und als Lösungsmittel vorzugsweise Dimethylacetamid verwendet.

Nach dem erfindungsgemäßen Verfahren können zur Herstellung der single clads auch andere Reaktionspartner extrudiert werden, die in herkömmlichen phenolischen Lösungsmitteln, z. B. Phenol oder substituierten Phenolen (halogenierten Phenolen), unlösliche, nicht mehr formbare Polyimide bilden.

Obwohl als Lösungsmittel vorzugsweiae Dimethylacetamid (DMAc) verwendet wird, können auch andere polare organische Lösungsmittel, zum Beispiel N,N-Dimethyl-methoxyacetamid, Dimethylformamid (DMF); Diäthylformamid: N-Methyl-2-Pyrrolidon (NMP) und Dimethylsulfoxyd (DMSO) eingesetzt werden. Als weitere Lösungsmittel können zum Beispiel N-Methylcaprolactam, Dimethylsulfon, Pyridin, Hexamethylphosphorsäuretriamid, N-Acetyl-2-Pyrrolidon, Tetramethylharnstoff und Tetramethylensulfon verwendet werden.

Die Heratellung der Polyamidsäure kann gemäß dem Stand der Technik, wie er beispielsweise in den US-Patentschriften 3 179 614 und 3 179 634 beschrieben ist, erfolgen.

In der Abbildung 1 wird eine bevorzugte Vorrichtung zur Durchführung des ersten Abschnitts des erfindungsgemäßen Verfahrens schematisch dargestellt. Abbildung 2 stellt den Querschnitt des Kondensations- bzw. Aushärtungsofens entlang der Linie 2-2 dar.

In der in Abb. 1 dargestellten Vorrichtung wird z. B. aus dem Dianhydrid und dem Diamin eine trockene Mischung mit einem Molverhältnis: Pyromellitsäuredianhydrid (PMDA) : 4,4'-Diaminodiphenyläther (DADE) zwischen 0,95 : 1 und 1,05 : 1 hergestellt. Diese Mischung wird einer gravimetrischen Dosiervorrichtung 3 zugeführt. Dann wird die Mischung mit genau gesteuerter Geschwindigkeit in ein Extruder-Reaktionsgefäß 4 eingespeist. Mit Hilfe einer Dosierpumpe 5 wird der in dem Extruderreaktionsgefäß 4 befindlichen trockenen Mischung ein polares Lösungsmittel zugesetzt. Das Molekulargewicht der Polyamidsäure wird durch das Molverhältnis von Dianhydrid zu Diamin bestimmt. Den optimalen Molekulargewichtsbereich der Polyamidsäure erreicht man bei einem Molverhältnis zwischen 0,98 und 1,02 und er wird als reduzierte Viskosität ($\eta_{red}$) einer 0,5-%-igen Lösung in 0,1 Mol/liter Lithiumbromid enthaltendem Dimethylacetamid gemessen. Dis reduzierte Viskosität der Polyamidsäure beträgt bei molaren Verhältnissen von 0,95 und 1,05 PMDA : DADE etwa 0,5 und liegt beim optimalen Verhältnis (zwischen 0,98 bis 1,02 PMDA : DADE) zwischen ca. 1,0 und 4,0. Bei einem molaren Verhältnis von 0,95 wurde ein durchschnittliches Molekulargewicht der gebildeten Polyamidsäure von 32 000 gefunden, bei 1,0 ca. 200 000, bei 1,03 ca. 35 000 (Bestimmung mit einem FIKA-Lichtstreuungsphotometer, Modell PGD 42 000 bei $\lambda$ = 436 nm).

Die Temperatur im Extruderreaktionsgefäß 4 sollte auf einem Niveau unter ca. 80°C gehalten werden; in der Praxis kann sie jedoch allmählich von ca. 20°C ausgehend gesteigert oder in Zonen mit ansteigender Temperatur auf maximal 80°C angehoben werden. Das Lösungsmittel wird in der ersten Zone des Extruderreaktionsgefäßes 4 zugesetzt. Die Verweilzeit im Extruderreaktionsgefäß 4 liegt im Bereich von 1 bis 5 Minuten. Am Ende dieser Verweilzeit ist die Reaktion zur Bildung der Polyamidsäure abgeschlosaen. Die Polyamidsäure mit einer reduzierten Viskosität von 0,5 bis 4,0, vorzugsweise mehr als 1,0 kann dann durch eine Schlitzdüse 6 auf ein Trägermaterial 7, bei dem es sich um eine von einer Spule oder Rolle 8 abgezogene Folie aus Kupfer oder einem anderen Metall oder aus einer Legierung oder um eine synthetische Folie oder um ein Flächengebilde aus einem Fasermaterial handeln kann, extrudiert werden.

Das mit der Polyamidsäurelösung beschichtete Substrat läuft dann 5 bis 20 Minuten oder länger zwecks Kondensation zum Polyimid durch einen Ofen 10, dem mittels einer Versorgungsleitung 11 Stickstoff zugespeist wird. Die Durchlaufzeit hängt von der Filmdicke ab, da bei erhöhter Dicke längere Zeiten erforderlich sind.

Es hat sich als wesentlich erwiesen, die Temperaturen in aufeinanderfolgenden Zonen im Ofen zu steuern; wenn jedoch diese Steuerung innerhalb dea genannten Bereiches erfolgt, bildet sich in sehr kurzer Zeit auf dem Subatrat 7 eine nicht mehr formbare, blasenfreie Polyimidschicht mit ausgezeichneten elektrischen und mechanischen Eigenschaften, die an dem Substrat mit einer Schälfestigkeit von über 4,0 N/cm haftet. Ohne Beschränkung auf eine theoretische Erläuterung dieses Ergebnisses ist anzunehmen, daß es erforderlich ist, daß das Lösungsmittel so langsam durch die Polyamidsäureschicht diffundiert und von der freiliegenden

Schichtoberfläche freigesetzt wird, daß sich keine Lösungsmittelblasen bilden können, die sich vergrößern und in der Polymerschicht-Matrix eingeschlossen bleiben. Auch muß ein Großteil des Lösungsmittels von der freiliegenden Seite der Polyamidsäureschicht freigesetzt werden, bevor die Imidisierung abgeschlossen ist. Ferner muß die Imidisierungsreaktion zu 80 bis 90 % bei Temperaturen unter ca. 180°C abgeschlossen werden, so daß auch der größere Teil des bei der Cyclisierungsreaktion gebildeten Wassers an die Schichtoberfläche diffundiert und freigesetzt wird.

Um das vorstehende Ziel zu erreichen, sind im der Kondensation dienenden Ofen mittels Widerstandselementen 12, 13, 14 und 15 folgende Heizzonen vorgesehen: In der ersten Zone wird die Temperatur mit einem elektrischen Widerstandselement 12 im Bereich von 100 bis 150°C gehalten; in der zweiten Zone wird die Temperatur auf ca. 130°C bis ca. 200°C, vorzugsweise unterhalb 180°C angehoben; in der dritten Zone wird die Temperatur auf ca. 200 bis 400°C erhöht, nachdem im wesentlichen das gesamte Lösungamittel zur Oberfläche diffundiert und entfernt und auch der größte Teil des bei der Cyclisierungsreaktion gebildeten Wassers entfernt ist; in der vierten Zone wird die Temperatur nochmals, vorzugsweise auf ca. 300 bis 600°C, angehoben. Jede dieser Zonen ist ungefähr gleich lang und daher ist auch die Verweilzeit in den einzelnen Zonen ungefähr gleich. Man kann jedoch die Geschwindigkeit des Durchlaufs und somit den Durchsatz erhöhen, indem man die erste und/oder zweite Zone verlängert oder der ersten Zone eine zusätzliche Heizzone vorschaltet, die man bei einer Temperatur von über 50°C, jedoch unter der Temperatur der ersten Zone, hält. Bei der in Abbildung 2 gezeigten Vorrichtung kann der Ofen 10 mit beweglichem Deckel 16 versehen sein, um einen leichten Zugang zum Schichtkörper im Ofen zu schaffen.

In einem zweiten Verfahrensabschnitt wird ein heißsiegelbares Polyimid oder eine Vorstufe, die zu einem heißsiegelbarem Polyimid gehärtet werden kann, auf die dem Trägermaterial abgewandte Seite der Schicht aus nicht mehr formbarem Polyimid aufgebracht.

Verwendet man an Stelle des heißsiegelbaren Polyimids seine Vorstufe, z. B. eine Polyamidsäurelösung, so muß diese anschließend gehärtet werden. Die so erhaltenen Grundkörper der erfindungsgemäßen flexiblen Mehrschicht-Laminate können nun auf verschiedene Weise weiterverarbeitet werden:

a) man verbindet zwei gleiche oder verschiedene dieser Grundkörper jeweils an ihren freiliegenden Oberflächen aus heißsiegelbarem Polyimid zu einem double clad. Dies geschieht bei einer Temperatur im Bereich von 150 bis 500°C und ggf. unter Anwendung von Druck. Ein bevorzugter Temperaturbereich liegt hierbei zwischen 250 und 400°C. Die beiden hierfür verwendeten Schichtkörper können sich in der Natur des Trägermaterials und/oder des nicht mehr formbaren Polyimids und/oder des heißsiegelbaren Polyimids und/oder in den Dicken der einzelnen Schichten unterscheiden. Je nach der Natur der beiden heißsiegelbaren Polyimide und/oder den Verfahrensbedingungen (Temperatur, Druck) entstehen dabei double clads, in denen noch zwei definierte Schichten aus heißsiegelbaren Polyimiden nachweisbar sind oder double clads, in denen die ursprünglich getrennten Schichten aus heißsiegelbaren Polyimiden nur noch eine definierte Schicht ergeben. Bei der hier beschriebenen Verfahrensvariante wird also das heißsiegelbare Polyimid auf beide der zu verbindenden Schichten aufgebracht.

b) man verbindet einen dieser Grundkörper mit einem single clad, das nach dem ersten Verfahrensschritt erhalten wird, das also nur aus Trägermaterial und nicht mehr formbarem Polyimid besteht. Hierbei wird die Schicht aus heißsiegelbarem Polyimid des Grundkörpers der erfindungsgemäßen Laminate mit der Schicht aus nicht mehr formbarem Polyimid des single clads verbunden, wiederum bei den unter a) genannten Temperaturen und ggf. unter Druck. Es entstehen Produkte, die den unter a) als zweite Möglichkeit genannten (nur eine definierte Schicht aus heißsiegelbarem Polyimid) entsprechen. Bei dieser Verfahrensvariante wird also die Schicht aus heißsiegelbarem Polyimid nur auf eine der zu verbindenden Schichten aufgebracht.

c) man bringt auf die Schicht aus heißsiegelbarem Polyimid bei einer Temperatur im Bereich von 150 bis 500°C eine Schicht aus einem Trägermaterial auf. Das Trägermaterial kann wiederum eines der oben beschriebenen Produkte sein und ist bevorzugt eine Metall-, insbesondere eine Kupferfolie, wie oben angegeben. Das Trägermaterial kann das gleiche sein wie dasjenige, das sich bereits auf dem Grundkörper befindet oder sich in seiner Natur und/oder Schichtdicke von diesem unterscheiden. Das Verbinden des Grundkörpers mit der Trägermaterialschicht erfolgt ggf. unter Anwendung von Druck. Die Schicht aus Trägermaterial kann jedoch auch die freiliegende Schicht eines fertigen gedruckten Schaltkreises sein. In diesem Fall wird also der Grundkörper der erfindungsgemäßen Laminate mit einem fertigen Schaltkreis verbunden und dient dabei also sog. "end cap"

d) ausgehend vom Grundkörper der Laminate oder von den Produkten, die nach den beschriebenen Verfahrensvarianten hergestellt wurden, können ggf. weitere Schichten auf die freiliegenden Außenflächen angebracht werden, um Mehrfach-clads zu erhalten.

Verwendet man bei der Herstellung von Laminaten, die zur Herstellung von double clads oder Mehrfach-clads oder für das "end cap"-Verfahren dienen soll, an Stelle des heißsiegelbaren Polyimids seine Vorstufe, z. B. eine Polyamidsäurelösung, so erfolgt zweckmäßigerweise die Aushärtung oder zumindest die weitgehende Aushärtung zum heißsiegelbaren Polyimid vor der Weiterverarbeitung. Bei der Aushärtung wird nämlich Wasser frei, das ebenso wie das Lösungsmittel der Polyamidsäurelösung entfernt werden muß. Diese Entfernung läßt sich leichter bewerkstelligen, wenn sie vor dem Verbinden mit anderen Schichten durchgeführt wird. Handelt es sich bei dem Material, das mit dem Grundkörper der erfindungsgemäßen Laminate verbunden werden soll, um eine für Wasser und Lösungsmitteldämpfe undurchlässige Substanz, z. B. eine Metallfolie, muß die Aushärtung zum heißsiegelbaren Polyimid im Normalfall sogar zwingend vor der Laminierung d.h. der Verbindung der Schichtkörper, erfolgen. Andernfalls können Qualitätseinbußen infolge

Blasenbildung im Laminat resultieren.

Das Verbinden des Grundkörpers mit anderen Schichten geschieht bei einer Temperatur, bei welcher das verwendete heißsiegelbare Polyimid formbar ist. Je nach der Art der zu verbindenden Schichten, der Art des heißsiegelbaren Polyimids sowie der gewünschten Laminateigenschaften kann das Verbinden durch Anwendung eines leichten oder höheren Drucks geschehen. Das heißsiegelbare Polyimid kann in Form seiner Lösung, einer Lösung seiner Vorstufe oder in fester Form aufgebracht werden. Im letzteren Fall kann das heißsiegelbare Polyimid z. B. als dünne Folie eingesetzt werden.

Eine Erhöhung der Bindefestigkeit zwischen nicht mehr formbarem Polyimid und heißsiegelbarem Polyimid läßt sich durch eine bevorzugte Ausführungsform des erfindungsgemäßen Verfahrens erzielen. Diese besteht darin, daß das heißsiegelbare Polyimid oder dessen Vorstufe vor vollständiger Aushärtung des nicht mehr formbaren Polyimids aufgebracht wird. Zweckmäßigerweise erfolgt das Aufbringen zu Beginn der zweiten Aushärtestufe des Verfahrens zur Herstellung der single clads, also zu einem Zeitpunkt, wo aus der zum nicht mehr formbaren Polyimid führenden Schicht bereits der wesentliche Anteil des Lösungsmittels verdampft ist. Anschließend wird dann in der zweiten Stufe die Aushärtung zum nicht mehr formbaren Polyimid vorgenommen. Gleichzeitig bildet sich, wenn eine Vorstufe des heißsiegelbaren Polyimids eingesetzt wurde, das heißsiegelbare Polyimid. Mit dieser bevorzugten Verfahrensvariante lassen sich Laminate herstellen, in denen die unterschiedlichen Polyimide durch gegenseitige Diffusion ineinander eingedrungen sind. Diese Verzahnung bewirkt eine Erhöhung der Klebefestigkeit der Polyimidschichten.

Im Anschluß an die beschriebenen Verfahrensschritte, die zum Grundkörper der erfindungsgemäßen Laminate führen, können, falls gewünscht, weitere Schichten aufgebracht werden. Nach einer weiteren Ausführungsform des Verfahrens lassen sich die oben beschriebenen Laminate herstellen, bei denen beide Seiten einer oder beider Schichten aus Trägermaterial direkt mit nicht mehr formbarem Polyimid verbunden sind. Hierzu stellt man nach dem beschriebenen ersten Verfahrensabschnitt zuerst ein single clad aus Trägermaterial und Polyimid her und härtet das Polyimid vollständig aus. Anschließend wird die zweite Seite des Trägermaterials mit einer Polyamidsäurelösung, die zu einem nicht mehr formbaren Polyimid führt, beschichtet und das Lösungsmittel verdampft. Anschließend kann direkt vollständig ausgehärtet oder vor dem vollständigen Aushärten das heißsiegelbare Polyimid bzw. dessen Vorstufe aufgebracht werden. Anschließend kann wie beschrieben vorgegangen werden, um weitere Ausführungsformen der Laminate zu erhalten. Die nach dieser Ausführungsform erhaltenen Laminate weisen somit eine Schichtstruktur mit folgender Reihenfolge auf: nicht mehr formbares Polyimid-Trägermaterial - nicht mehr formbares Polyimid - heißsiegelbares Polyimid, woran sich ggf. weitere Schichten anschließen.

Die Erfindung wird nunmehr durch Ausführungsbeispiele veranschaulicht.

**Beispiele 1 bis 3:**

Diese Beispiele veranschaulichen den ersten Verfahrensabschnitt, der zu single clads führt, die nach den in den nachfolgenden Beispielen angegebenen Verfahrensvarianten zu den erfindungsgemäßen Laminaten weiterverarbeitet werden können.

**Beispiel 1**

In einem handelsüblichen Pulvermischer wurde eine trockene Mischung aus Pyromellitsäuredianhydrid (PMDA) und 4,4'-Diaminodiphenyläther (DADE) hergestellt. Insgesamt wurden 5,0 kg PMDA und 4,54 kg DADE (molares Verhältnis PMDA : DADE 1,01) in den Mischer eingewogen und danach 48 Stunden auf der höchsten Geschwindigkeitsstufe gemischt. Anschließend wurden ca. 1,6 kg der Mischung in eine gravimetrische Dosiervorrichtung gegeben, welche die Mischung mit einer Geschwindigkeit von ca. 200 Gramm pro Stunde einem Doppelschneckenextruder mit negativer Einspeisung (negative-feed extruder) zuführte. In der ersten Extruderstufe, die bei 20°C gehalten wurde, wurde DMAc mit einer Geschwindigkeit von ca. 430 Gramm pro Stunde zugesetzt, so daß eine Feststoffkonzentration von 31,7 Gew.-% erhalten wurde. Während der restlichen Verweilzeit im Extruder wurde die Temperatur in aufeinanderfolgenden Zonen auf 50°C erhöht. Dabei bildete sich eine Polyamidsäure mit einer reduzierten Viskosität von 1,67, die aus dem Extruderzylinder durch eine Düse für dünne Folien gepreßt wurde. Die Düsenöffnung hatte einen rechteckigen Querschnitt mit den Maßen 200 x 0,35 mm. Der Druck am Düsenkopf betrug 85 bar. Die Polyamidsäurelösung wurde auf eine 35 µm dicke Bahn aus gewalzter getemperter Kupferfolie (Oak F-111) extrudiert und das Laminat wurde dann in einen Ofen mit vier gleichlangen Temperaturzonen von 140°C, 180°C, 350°C und 400°C unter einer Stickstoffatmosphäre eingeleitet. Die Gesamtverweilzeit des Laminats betrug 10 Minuten. Während dieser Zeit wurde die Polyamidsäure praktisch vollkommen in das Polyimid umgesetzt. Die Polyimidfolie haftete fest an dem Kupfersubstrat und war frei von Blasen und Unterbrechungen.

Bei der vorgenannten Oak F-111-Kupferfolie handelt es sich um ein Produkt der Firma Oak Materials Group Inc., USA das die Anforderungen der IPC-CF 150 E erfüllt.

**Beispiel 2**

Eine zweite 1,6-kg Probe der Mischung wurde der gleichen Behandlung wie im Beispiel 1 unterzogen, jedoch mit dem Unterschied, daß nunmehr eine 70 µm dicke Kupferfolie (Oak F-111) als Substrat diente. Der Polyimidfilm haftete fest an der Kupferfolie und war frei von Blasen und Unterbrechungen. Die Eigenschaften der Laminate aus den Beispielen 1 und 2 sind in der nachfolgenden Tabelle zusammengestellt.

**Tabelle**

| Eigenschaft (Polyimidschicht) | Beispiel 1 | Beispiel 2 | Prüfung |
|---|---|---|---|
| Durchschlagsfestigkeit, KV/$10^{-3}$ inch bei 60 Hz | 4,4 | 4,35 | ASTM D-149 |
| Dielektrizitätskonstante bei 1 KHz und 25°C | 4,0 | 3,9 | ASTM D-150 |
| Dielektrischer Verlustfaktor bei 1 KHz und 25°C | 0,0047 | 0,0039 | ASTM D-150 |
| Zugfestigkeit, $N/mm^2$ | 105 | 110 | ASTM D882 |
| Bruchdehnung, % | 45 | 31 | ASTM D882 |
| Dichte, $g/cm^3$ | 1,42 | 1,42 | ASTM D1505 |
| Dicke, µm | 66 | 61 | ASTM D374 |
| LOI | 40 | 40 | ASTM D2863 |
| **Eigenschaft (Laminat)** | | | |
| Schälfestigkeit, N/cm | 8,2 | 4,8 | IPC TM 650 2.4.9 |
| Verhalten beim Löten ohne weitere Vorbehandlung | kleine Blasenbildung kein Ablösen | keine Blasenbildung kein Ablösen | IPC TM 650 2.4.13 (leicht modifiziert) |

**Beispiel 3**

Ein Dreihalskolben wird mit 8,17 g PMDA beschickt, dem 7,58 g DADE, gelöst in 60 g DMAc zugesetzt wird. Das DADE war vorher unter ständigem Rühren bei voller Geschwindigkeit in DMAc gelöst worden. Das Molverhältnis PMDA : DADE betrug 0,99 : 1,00. Danach wurden in das Reaktionagefäß weitere 29,25 g des DMAc gegeben, das vorher zum Ausspülen des Kolbens verwendet wurde, in dem DADE gelöst wurde. Die Reaktion wird 80 Minuten unter Rühren bei einer Temperatur von 22°C in einer Sticksotffatomosphäre fortgesetzt. Ein Teil der entstandenen Polyamidsäurelösung wird auf eine vorher mit einer Eisen-III-chloridlösung aus 30 g $FeCl_3$, 60 $cm^3$ 12 n HCl und 180 $cm^3$ Wasser geätzte Nickel-Chrom-Folie einer Dicke von 23 µm (Inconel der Fa. Somers Thin-Strip/Brass Group, Olin Corp., Waterbury, Connecticut) aufgegossen. Die Inconel-Folie bestand aus einer Legierung mit Nickel als Hauptbestandteil sowie Chrom und Eisen. Die aufgegossene Polyamidsäurelösung wird auf eine Dicke von 356 µm mit Hilfe eines Glasstabes, auf den Kupferdraht mit einem Durchmesser von 356 µm gewickelt ist, ausgezogen. Die Legierungsfolie wird auf eine Glasplatte aufgebracht und mit einem Klebestreifen befestigt. Der Film wird 20 Minuten bei 70°C getrocknet und dann in einem Vakuumtrockner bei einem Unterdruck von ca. 2 mm Hg bei 160°C in einer Stickstoffatmosphäre behandelt. Die Temperatur des Trockners wird dann innerhalb von 4 1/2 Stunden auf 310°C erhöht. Wenn der Film eine Temperatur von 160°C erreicht hat, was innerhalb von ca. 1 - 2 Minuten der Fall ist, ist bereits der größte Teil des Lösungsmittels ausgetrieben, wie man an Hand der Farbe des Films, einem klaren, hellen Gelb, feststellen kann. Der ausgehärtete trockene Film besaß eine Dicke von 25 µm Daneben wurde eine gemäß Beispiel 1 erhaltene Polyamidsäure-Probe auf 22 Gew.-% Polyamidsäure und eine reduzierte Viskosität ($\eta_{red}$) von 1,22 mit DMAc verdünnt und auf eine Legierungsfolie von 58 µm Dicke aus einer Kupfer-Nickel-Legierung mit ca. 70 % Cu und ca. 30 % Ni (Cupro-Nickel 30 # 715 von Somers Thin-Strip/Brass Group, Olin Corp., Waterbury, Connecticut) mit einer gerauhten ("machine scrubbed") Oberfläche aufgegossen und mit einer Rakel bis zu einer Naßfoliendicke von 356 µm verstrichen. Der aufgegossene Film wurde ebenfalls entsprechend der in diesem Beispiel angegebenen Methode getrocknet und ausgehärtet. Beide Filme besaßen eine extrem hohe Schälfestigkeit, während eine ähnliche Filmprobe, die sich auf einer glänzenden, unbehandelten Legierungsfolie befindet, sich leicht abschälen läßt (Schälfestigkeit 0,7 N/cm). Weder die auf der geätzten noch die auf der aufgerauhten Folie befindliche Polyimidschicht ließ sich ohne Beschädigung der Polyimid-Folie abtrennen, um auf diese Weise die Schälfestigkeit zu messen. Nach einer siebentägigen Behandlung bei 260°C wies der Polyimid-Film auf der gerauhten Folie eine ausgezeichnete Haftung und Geschmeidigkeit auf.

**Beispiel 4:**

In einem Rührgefäß wurde aus 9,36 g BTDA (3,4,3',4'-Isomeres), 5,64 g DADE und 85 g N-Methylpyrrolidon eine 15-%-ige Polyamidsäure (PAC)-Lösung hergestellt. Mit Hilfe eines Spiralauftraggeräts (100 µm-Draht) wurde auf single-clads, bestehend aus 35 µm dicker, messingbeschichteter Kupferfolie (Gould) und 25 µm dickem Polyimid aus den Komponenten PMDA und DADE die oben beschriebene PAC-Lösung aufgestrichen. Durch anschließende Temperaturbehandlung der beschichteten clads in Stickstoffatmosphäre aufeinanderfolgend 30 min. bei 80°C, 15 min. bei 130°C, 15 min. bei 150°C, 60 min. bei 300°C und 30 min. bei 400°C wurden zwei Körper aus je einem untrennbaren Cladmaterial mit der Schichtenfolge: messingbeschichtetes Kupfer, PMDA/DADE-Polyimid und BTDA/DADE-Polyimiderhalten.

Vor der Laminierung zu Doppel-clads wurden die so hergestellten single clads 2 Stunden bei 400°C im Stickstoffstrom konditioniert. Die Laminierung von jeweils zwei ca. 20 x 10 cm großen Einfach-clads erfolgte unter den in Tab. 1 angegebenen Bedingungen so daß sich die BTDA/DADE-Polyimidschichten der beiden clads berührten. Die erhaltenen Doppel-clads waren glatt. Schälfestigkeiten der Doppel-clads sind ebenfalls aus Tabelle 1 zu ersehen. Die Polyimidschichten lösten sich beim Versuch der Trennung gemeinsam vom Metall, ohne daß es zu einer Trennung der Polyimidschichten kam.

**Tabelle 1:**

| | Laminierungsbedingungen | | | Schälfestigkeit N/cm zwischen Polyimid und Metall |
|---|---|---|---|---|
| | Temp. °C | Druck $kp/cm^2$ | Zeit Min. | |
| 1. | 370 | 320 | 180 | 9,1 |
| 2. | 395 | 320 | 30 | 9,3 |
| 3. | 395 | 110 | 30 | 7,6 |
| 4. | 393 | 320 | 30 | 8,2 |

Nach Ablösen der Kupferschichten von einem Doppel-clad wurde ein Polyimidverbund mit 2 x 25 µm PMDA/DADE-Polyimid und 2 x 9 µm BTDA/DADE-Polyimid erhalten. Folgende mechanischen Eigenschaften wurden festgestellt:

| | |
|---|---|
| Reißfestigkeit: | 117 $N/mm^2$ |
| Reißdehnung: | 29 % |
| Elastizitätsmodul: | 1800 $N/mm^2$ |

Das Polyimidlaminat war blasenfrei nach dem Ätzen von Leiterbahnen und Eintauchen in ein Lötbad. Die hier und in weiteren Beispielen angegebene Konditionierung von single clads im $N_2$-Strom stellt keine erforderliche Maßnahme dar, es können z. B. zwei single clads direkt nach ihrer Herstellung miteinander verbunden werden.

**Beispiel 5** (Vergleichsbeispiel):

Im Vergleich zum Beispiel 4 wurden zwei nicht mit BTDA/DADE-Polyimid beschichtete Einfach-clads aus 35 µm zwei dickem messingbeschichtetem Kupfer und 25 µm dickem PMDA/DADE-Polyimid 4 Stunden lang bei 395°C und 320 $kp/cm^2$ paarweise verpreßt. In diesem Fall konnte lediglich eine Klebefestigkeit der Polyimidschichten gegeneinander von 3,40 N/cm festgestellt werden. Beide Polyimidschichten trennten sich voneinander, bevor es zu einer Ablösung einer Polyimidschicht vom Metall kam.

**Beispiel 6:**

PAC-Lösung wurde aus einer Pulvermischung von 499,07 g PMDA und 458,29 g DADE mit einer Dosierung von 200 g/h und N-Methylpyrrolidon (NMP) mit einer Dosierung von 570 g/h in einem Zweischneckenextruder hergestellt und als 29,3-%-ige Lösung mit 4,83 ml/min über eine Schlitzdüse auf 100 µm dicke Aluminiumfolie aufgetragen. Anschließend wurde der Naßfilm auf der Aluminiumfolie bei 120°, 140°, 180°C und 200°C bei einer durchschnittlichen Verweildauer von 2,5 min. bei jeder Temperaturstufe getrocknet und teilweise imidisiert. Auf die teilgehärtete Polymerschicht wurde mit Hilfe eines Spiralauftraggerätes (40 µm Drahtspirale) eine weitere Schicht 15-%-iger PAC-Lösung, hergestellt aus 9,25 g BTDA, 5,75 g DADE und 85,0 g NMP in einem Rührgefäß, aufgestrichen. Das derart beschichtete clad wurde unter Stickstoff aufeinanderfolgend 30 min. bei 80°C, 15 min. bei 130°C, 15 min. bei 150°C, 60 min. bei 300°C und 30 min. bei 400°C getrocknet und gehärtet. Das BTDA war das 3,4,3',4'-Isomere.

Vor der weiteren Verarbeitung wurden die clads nochmals 2 h in Stickstoffatmosphäre bei 200°C getrocknet. Zwei dieser clads wurden unter Kontakt der beiden BTDA/DADE-Polyimidschichten bei einem Druck von 320 kp/$cm^2$ und einer Temperatur von 374°C drei Stunden lang verpreßt. Das Doppelclad war glatt und blasenfrei. Die Schälfestigkeit betrug 7,30 N/cm.

Bei der gewaltsamen Trennung des Laminats lösten sich die Polyimidschichten immer gemeinsam von einer Aluminiumfolie, ohne daß sich die Polyimidschichten voneinander trennten.

**Beispiele 7 - 9:**

Aus einer Pulvermischung von 605,0 g PMDA und 555,6 g DADE, die mit 200 g/h dosiert wurde, und N-Methylpyrrolidon (420 g/h) wurde in einem Zweischneckenextruder 31,7-%-ige PAC-Lösung hergestellt und in einer Menge von 3,25 ml/min über eine Schlitzdüse auf eine messingbeschichtete 25 µm dicke Kupferfolie (Gould-Metal, Eichstetten) extrudiert, die sich mit einer Geschwindigkeit von 12 m/h vorwärtsbewegte. Der flüssige PAC-Film wurde in Stickstoffatmosphäre bei 140°C 5 min lang getrocknet.

An einer Probe wurde nach vollständiger Trocknung und Imidisierung der Polymerschicht bei Temperaturen bis 400°C und Abätzen des Kupferfilms eine Polyimidschichtdicke von 25 µm gemessen.

Jeweils vorgetrocknete und teilimidisierte Einfach-clads wurden mit Hilfe eines Spiralauftraggerätes (20 µm Drahtspirale) mit PAC-Lösungen folgender Zusammensetzung bestrichen:

Beispiel 7: 25-%-ige PAC aus 154,76 g (3,4,3',4')-BTDA und 95,24 g 4,4'-Diaminodiphenylmethan (DDM) und 750 g NMP, $\eta_{red}$ (DMAc/ LiBr) = 1,58.

Beispiel 8: 27-%-ige PAC aus 25,42 g (3,4,3',4')-BTDA, 19,59 g 4,4'-Diaminodiphenylsulfon (DDS), 60 g Anisol und 61,6 g NMP, $\eta_{red}$ (DMAc/LiBr) = 0,69

Beispiel 9: 20-%-ige PAC aus 18,58 g (3,4,3',4')-BTDA, 5,71 g DADE, 5,71 g DDS, 18,0 g Anisol und 102 g NMP, $\eta_{red}$ (DMAc/LiBr) = 2,02

Die PAC beschichteten Einfach-clads wurden in Stickstoffatmosphäre 30 min. bei 80°C, mit 3°C/min. bis auf 400°C steigender Temperatur und 45 min. bei 400°C getrocknet und imidisiert. Je zwei gleiche vollständig gehärtete Einfach-clads wurden anschließend mit innenliegenden Polyimidoberflächen 30 min. bei 300°C und einem Druck von 300 kp/$cm^3$ zu glatten, blasenfreien Doppel-clads laminiert. Die Haftfestigkeit der einzelnen Polyimidschichten untereinander war so groß, daß sich die Polyimidschichten beim gewaltsamen Trennen des Doppelclads von Kupfer ablösten.

Im Falle des Beispiels 8 wurde nach Abätzen der Metallschichten (ca. 20-%-ige $H_2SO_4$, die 3,5 % $H_2O_2$ enthielt) ein dielektrischer Verlustfaktor von $4,9 \cdot 10^{-3}$ (bei 1 kHz und 25°C) bestimmt.

**Beispiel 10:**

Aus einer Pulvermischung von 6050,0 g PMDA und 5556,4 g DADE wurde bei einer Dosierung von 200 g/h unter Zusatz von NMP bei einer Dosierung von 575 g/h in einem Doppelschneckenextruder eine 29,6-%-ige PAC-Lösung hergestellt. Die Reaktionstemperatur betrug maximal 50°C. Die PAC besaß eine reduzierte Viskosität $\eta_{red}$ von 1,22. Diese Polymerlösung wurde über eine Schlitzdüse in einer Menge von 3,58 ml/min auf ein messingbeschichtetes, 35 µm dickes, NMP-feuchtes Kupferband extrudiert und anschließend in einem kontinuierlichen Verfahren bei 140°C 5 min. lang vorbehandelt. Aus einer zweiten Schlitzdüse wurde auf diese erste Polymerschicht eine PAC-Lösung, bestehend aus 135,7 g BTDA, 83,43 g DADE, 80 g Anisol und 700 g NMP (Lösungsviskosität bei 20°C durch Rotovisko: $LV_{20}$ = 6500 Poise, $\eta_{red}$ (DMAc/LiBr) = 2,22) mit einer Förderleistung von 1,23 ml/min aufgetragen, wobei das Anisol zusammen mit NMP das Lösungsmittel darstellt. Anschließend wurden beide Polymerschichten, die vorbehandelte und die noch viskosflüssige in Temperaturstufen von 140, 180, 300 und 400°C in Stickstoffatmosphäre gemeinsam vollständig gehärtet, wobei die Verweilzeit pro Temperaturstufe 2,5 min. betrug. Die Gesamtschichtdicke der beiden Polyimidlagen war 33 bis 35 µm, wobei 29 - 30 µm auf die PMDA/DADE-Polyimidschicht entfielen.

10 x 20 cm große so hergestellte Cladstücke wurden nochmals bei 400°C 2 h in Stickstoffatmosphäre getrocknet und anschließend paarweise unter Kontakt der Polyimidoberflächen in einer Plattenpresse bei 295°C und 320 kp/$cm^3$ 30 min. lang und Abkühlen bis 100°C unter Druck zu blasenfreien Doppel-Clads mit einer Schälfestigkeit von Polyimid an Kupfer von 12 bis 20 N/cm laminiert. Die einzelnen Polyimidschichten waren unlösbar verklebt. Nach Abätzen des Kupfers wurden folgende Eigenschaften des Polyimidlaminats festgestellt:

Reißfestigkeit: 118 N/mm²
Reißdehnung: 24 %
Elastizitätsmodul: 1840 N/mm²
Dicke: 70 µm
Dielektrischer Verlustfaktor 4,5 · $10^{-3}$ (bei 1 kHz und 25° C)

**Beispiel 11:**

Unter denselben Bedingungen wie in Beispiel 10, jedoch mit größerer Fördermenge an BTDA/DADE-PAC wurden Einfach-clads aus messingbeschichtetem, 35 µm dickem Kupferband, 25 - 30 µm dicker PMDA/DADE-Polyimidschicht und 15 µm dicker BTDA/DADE-Polyimidschicht hergestellt, PAC aus PMDA/DADE wurde mit 3,25 ml/min., PAC aus BTDA/DADE mit 2,42 ml/min. aus den Schlitzdüsen gefördert. Die Einfach-clads wurden sofort unter den ebenfalls in Beispiel 10 aufgeführten Bedingungen, jedoch ohne zusätzliche Trocknung, zu blasenfreien Doppel-clads mit einer Polyimidgesamtschichtdicke von 85 - 90 µm laminiert. Die Schälfestigkeit von 38 x 18 cm großen Doppel-clads betrug 12,5 N/cm, die elektr. Durchschlagfestigkeit 3,6 kV/25 µm. Der dielektrische Verlustfaktor wurde nach Abätzen des Metalls bestimmt. Er betrug 4,2 · $10^{-3}$ bei 1 kHz und 25° C.

**Beispiel 12**

Dieses Beispiel beschreibt die Herstellung eines double clads mit dem Aufbau Trägermaterial/nicht mehr formbares Polyimid/heißsiegelbares Polyimid/Trägermaterial. Ein Clad bestehend analog zu Beispiel 4 aus messingbeschichtetem Kupfer, PMDA/DADE-Polyimid und BTDA/DADE Polyimid wurde mit Kupferfolie (Oak F-111) und Aluminiumfolie laminiert. Die Metallfolien waren hierbei mit der BTDA/DADE-Polyimidschicht in Kontakt. Laminierungsbedingungen und Klebefestigkeit sind in der folgenden Tabelle angegeben.

**Tabelle**

| | Laminierungsbedingungen | | | Klebefestigkeit, cN/cm | |
|---|---|---|---|---|---|
| | Temp. °C | Druck kp/cm² | Zeit Min. | Clad/Kupfer | Clad/Aluminium |
| 1. | 370 | 320 | 25 | 500 | 600 |
| 2. | 370 | 320 | 60 | 650 | 450 |
| 3. | 370 | 320 | 180 | 800 | 730 |
| 4. | 395 | 320 | 30 | 1100 | 800 |
| 5. | 395 | 110 | 30 | 1000 | 750 |
| 6. | 395 | 320 | 240 | 550 | 900 |

**Beispiel 13**

28,6-%-ige PAC-Lösung wurde in einem Doppelschneckenextruder aus einer Pulvermischung von 6050,0 g PMDA und 5556,4 g DADE bei einer Dosierung von 200 g/h und dem Lösungsmittel NMP bei einer Dosierung von 500 g/h und einer maximalen Reaktionstemperatur von 55° C hergestellt und über eine Schlitzdüse in einer Menge von 3,58 ml/min auf ein 100 µm dickes Aluminiumband extrudiert. Das Metallband wurde mit einer Geschwindigkeit von 12 m/h transportiert. Der flüssige PAC-Film wurde auf dem Aluminiumband liegend bei 140 und 180° C vorgetrocknet und z.T. imidisiert, wobei die Verweildauer pro Temperaturstufe 2,5 min betrug. Auf den teilgehärteten Film wurde eine 19-%-ige PAC-Lösung aus 117,2 g BTDA 72,8 g DADE und 810 g NMP kontinuierlich aufgetragen und mit Hilfe einer Drahtspirale (500 µm Draht) gleichmäßig verteilt.

Anschließend wurde das Clad mit teilgehärteter Polyimidschicht und darauf aufliegendem PAC-Flüssigfilm in 4 Temperaturstufen (140, 180, 300, 400° C) getrocknet, wobei die Verweilzeit pro Temperaturstufe 2,5 min betrug.

Nach Absätzen von Aluminium mit Salzsäure wurden folgende Polyimideigenschaften ermittelt:

| | |
|---|---|
| Schichtdicke | : 25 µm |
| elektr. Durchschlagfestigkeit | : 6,3 kV/25 µm |
| Dielektrizitätskonstante | : 2,3 |
| dielektr. Verlustfaktor | : $3{,}7 \cdot 10^{-3}$ |
| Reißfestigkeit | : 131 $N/mm^2$ |
| Reißdehnung | : 39 % |
| Elastizitätsmodul | : 2560 $N/mm^2$ |

Bei den vorangegangenen Beispielen wurden folgende Abkürzungen benützt:

| | |
|---|---|
| PAC | = Polyamidsäure |
| PMDA | = Pyromellitsäuredianhydrid |
| DADE | = 4,4'-Diaminodiphenyläther |
| BTDA | = Benzophenon-3,4,3',4'-tetracarbonsäuredianhydrid |
| NMP | = N-Methylpyrrolidon |
| DMAc | = N,N-Dimethylacetamid |

Das PMDA/DADE-Polyimid ist ein nicht mehr formbares Polyimid, das BTDA/DADE-Polyimid ist ein heißsiegelbares Polyimid.

**Patentansprüche**

1. Flexibles Mehrschicht-Laminat, bestehend aus mindestens einer Schicht aus einem Trägermaterial und mindestens einer Schicht aus einem vollaromatischen, nicht mehr formbaren Polyimid, wobei mindestens eine Schicht aus nicht mehr formbarem Polyimid an einer Seite direkt an einer Schicht aus Trägermaterial mit einer Schälfestigkeit von mindestens 4,0 N/cm haftet, wobei dieses nicht mehr formbare Polyimid in phenolischen Lösungsmitteln unlöslich ist und diese Schicht aus nicht mehr formbarem Polyimid eine Zugfestigkeit von 100 bis 150 $N/mm^2$, eine Bruchdehnung von 15 - 100 % und einen dielektrischen Verlustfaktor von $1{,}5 \times 10^{-3}$ bis $5 \times 10^{-3}$ bei 1 kHz aufweist, und wobei sich auf der dem Trägermaterial abgewandten Seite dieser Schicht aus nicht mehr formbarem Polyimid eine Schicht aus einem heißsiegelbaren Polyimid befindet, das nicht unterhalb von 200°C schmilzt und bei einer Temperatur im Bereich zwischen 150°C und 500°C, ggf. durch Anwendung eines Drucks, formbar ist.

2. Laminat nach Anspruch 1, dadurch gekennzeichnet, daß Sich auch auf der anderen Seite der Schicht aus heißsiegelbarem Polyimid eine Schicht aus einem vollaromatischen, nicht mehr formbaren Polyimid befindet, wobei die dem heißsiegelbaren Polyimid abgewandte Seite dieser Schicht aus nicht mehr formbarem Polyimid direkt an einer Schicht aus Trägermaterial haftet und wobei die in dem Laminat enthaltenen Schichten aus nicht mehr formbaren Polyimiden und/oder die Schichten aus Trägermaterialien jeweils gleich oder verschieden sind.

3. Laminat nach den Ansprüchen 1 bis 2, dadurch gekennzeichnet, daß mindestens eine Schicht aus Trägermaterial auf beiden Seiten mit je einer Schicht aus nicht mehr formbarem, vollaromatischem Polyimid direkt verbunden ist.

4. Laminat nach den Ansprüchen 1 bis 3, dadurch gekennzeichnet, daß die Verbindung zwischen nicht mehr formbarem Polyimid und heißsiegelbarem Polyimid durch gegenseitiges Eindringen dieser Materialien ineinander bewirkt ist.

5. Laminat nach den Ansprüchen 1 bis 4, dadurch gekennzeichnet, daß der Schichtverbund, der aus nicht mehr formbarem Polyimid und aus heißsiegelbarem Polyimid besteht, eine Zugfestigkeit von 100 bis 150 $N/mm^2$, eine Bruchdehnung von 15 bis 100 % und einen dielektrischen Verlustfaktor von $1{,}5 \times 10^{-3}$ bis $5 \times 10^{-3}$ bei 1 kHz aufweist.

6. Laminat nach den Ansprüchen 1 bis 5, dadurch gekennzeichnet, daß die Dicke jeder Schicht aus nicht mehr formbarem Polyimid 1 µm bis 1 mm beträgt.

7. Laminat nach Anspruch 6, dadurch gekennzeichnet, daß die Schichtdicke 1 µm bis 15 µm beträgt.

8. Laminat nach Anspruch 6, dadurch gekennzeichnet, daß die Dicke jeder Schicht aus nicht mehr formbarem Polyimid 10 µm bis 1 mm beträgt.

9. Laminat nach Anspruch 8, dadurch gekennzeichnet, daß die Dicke jeder Schicht aus nicht mehr formbarem Polyimid 50 - 250 µm beträgt.

10. Laminat nach den Ansprüchen 1 bis 9, dadurch gekennzeichnet, daß die Dicke der Schicht aus heißsiegelbarem Polyimid 0,5 bis 3 µm beträgt.

11. Laminat nach den Ansprüchen 1 bis 9, dadurch gekennzeichnet, daß die Dicke der Schicht aus heißsiegelbarem Polyimid 2 bis 50 µm beträgt.

12. Laminat nach den Ansprüchen 2 bis 11, dadurch gekennzeichnet, daß alle Schichten aus nicht mehr formbarem Polyimid die gleiche Dicke aufweisen.

13. Laminat nach den Ansprüchen 1 bis 12, dadurch gekennzeichnet, daß die Schicht(en) aus nicht formbarem Polyimid aus einem Polyimid besteht bzw. bestehen, das die folgende sich widerholende Struktur aufweist

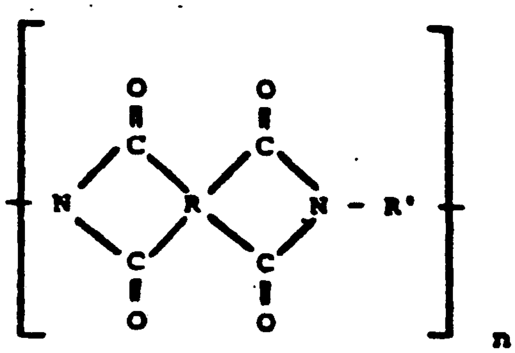

wobei
R ein vierwertiger aromatischer Rest
R' ein zweiwertiger aromatischer Rest ist.

14. Laminat nach Anspruch 13, dadurch gekennzeichnet, daß

R 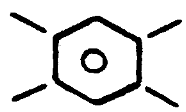 und R' 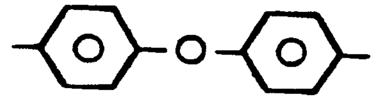

darstellen.

15. Laminat nach den Ansprüchen 1 bis 14, dadurch gekennzeichnet, daß die Schicht oder die Schichten aus Trägermaterial jewoils unabhängig voneinander aus einer Folie aus Metall oder einer Metallegierung oder aus einer Polymerfolie oder aus einem Flächengebilde aus einem Fasermaterial besteht bzw. bestehen.

16. Laminat nach Anspruch 15, dadurch gekennzeichnet, daß das Trägermaterial eine Folie aus Kupfer, Nickel, Aluminium, oder einer Legierung, welche eines oder mehrere dieser Metalle als wesentlichen Bestandteil enthält, oder eine Folie aus amorphem Metall oder eine Folie aus Stahl ist.

17. Laminat nach Anspruch 16, dadurch gekennzeichnet, daß die Folie aus gewalztem, getempertem Kupfer oder aus einer gewalzten, getemperten Kupferlegierung besteht.

18. Laminat nach den Ansprüchen 16 oder 17, dadurch gekennzeichnet, daß die Schichtdicke der Folie 5 bis 250 µm beträgt.

19. Laminat nach Anspruch 18, dadurch gekennzeichnet, daß die Schichtdicke der Folie 10 bis 50 µm beträgt.

20. Laminat nach den Ansprüchen 1 bis 19, dadurch gekennzeichnet, daß das heißsiegelbare Polyimid das Reaktionsprodukt von Benzophenon-tetracarbonsäuredianhydrid (BTDA) oder von einem Gemisch aus BTDA und Pyromellitsäuredianhydrid mit 4,4'-Diaminodiphenyläther, 3,3'-Diaminodiphenyläther, 3,3'-Diaminodiphenylsulfon, 3,3'-Diaminodiphenylmethan, 4,4'-Diaminodiphenylsulfon, 4,4'-Diaminodiphenylmethan, Benzidin oder mit Gemischen dieser Diamine ist.

21. Laminat nach den Ansprüchen 1 bis 19, dadurch gekennzeichnet, daß das heißsiegelbare Polyimid das Reaktionsprodukt eines Dianhydrids mit einem Diamin ist, wobei das Dianhydrid die Formel

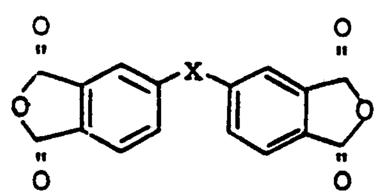

aufweist, worin X für ein Sauerstoffatom steht oder für eine $C_nF_{2n}$-Gruppe mit n = 1 bis 10 oder für die Gruppierung

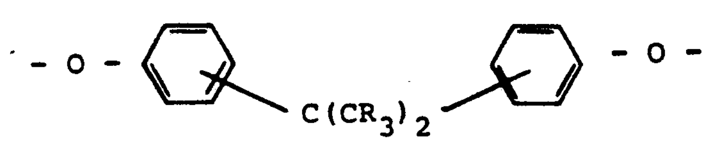

steht, in der R ein Wasserstoffatom oder ein Fluoratom bedeutet und in der die $(CR_3)_2$-Gruppe sich jeweils in meta- oder para-Stellung zum betreffenden Sauerstoffatom befindet und wobei das Diamin die Formel

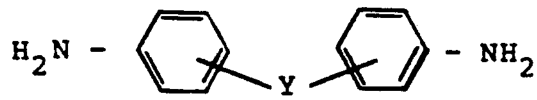

oder die Formel

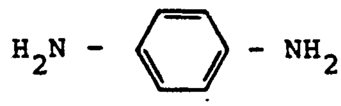

aufweist, wobei Y für ein Sauerstoffatom steht oder für eine $C_nF_{2n}$-Gruppe mit n = 1 bis 10 oder für eine Carbonylgruppe und wobei sich Y jeweils in meta- oder para-Stellung zur betreffenden Aminogruppe befindet.

22. Laminat nach den Ansprüchen 1 bis 21, dadurch gekennzeichnet, daß die Schicht aus heißsiegelbarem Polyimid ein Fasermaterial enthält.

23. Laminat nach Anspruch 22, dadurch gekennzeichnet, daß das Fasermaterial aus Glasfaser, Aramidfaser, Kohlenstoffaser, und/oder Kieselsäurefaser besteht.

24. Laminat nach den Ansprüchen 22 oder 23, dadurch gekennzeichnet, daß das Fasermaterial ein Gewebe aus Endlosfilamenten ist.

25. Laminat nach den Ansprüchen 2 bis 24, dadurch gekennzeichnet, daß die Schichten aus nicht mehr formbaren Polyimiden durch zwei Schichten aus heißsiegelbarem Polyimid miteinander verbunden sind.

26. Laminat nach den Ansprüchen 1 und 3 bis 24, dadurch gekennzeichnet, daß sich auf der Schicht aus heißsiegelbarem Polyimid auf der dem nicht mehr formbaren Polyimid abgewandten Seite eine Schicht aus Trägermaterial befindet.

27. Verfahren zur Herstellung von Laminaten nach den Ansprüchen 1 bis 26, das die folgenden Schritte aufweist: es wird eine Polyamidsäurelösung aus einer aromatischen Tetracarbonsäure oder deren Dianhydrid und einem primären aromatischen Diamin gebildet, indem die aromatische Tetracarbonsäure oder deren Dianhydrid mit dem aromatischen Diamin im Molverhältnis von 0,95 : 1 bis 1,05 : 1 in einem polaren organischen Lösungsmittel zu einer Polymerverbindung aus einer Polyamidsäure mit der Formel

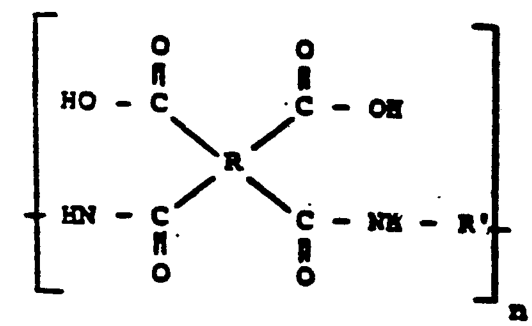

umgesetzt wird, in der

R einen aromatischen vierwertigen Rest und

R' einen zweiwertigen aromatischen Rest darstellen und

n ausreicht, um eine Polyamidsäure mit einem $\eta_{red}$-Wert von mindestens 0,5 zu erhalten; die erhaltene Polyamidsäurelösung wird ohne Zwischenschicht auf ein Trägermaterial aufgebracht und das Lösungsmittel in einer ersten Stufe, deren Temperatur im Bereich von 100 bis 200°C liegt, in situ entfernt, wobei im wesentlichen die gesamte Lösungsmittelmenge entfernt wird; der Film wird in einer zweiten Stufe, bei der die Temperatur mehr als 200°C, vorzugsweise mehr als 300°C beträgt, in situ zu einem in phenolischen Lösungsmitteln unlöslichen, nicht mehr formbaren Polyimid ausgehärtet, wobei mindestens 95 % der Polyamidsäure zu Polyimid umgesetzt werden; auf die dem Trägermaterial abgewandte Seite der Schicht aus nicht mehr formbarem Polyimid wird eine Schicht eines bei einer Temperatur im Bereich zwischen 150°C und 500°C formbaren Polyimids aufgebracht oder eine zu einem derart formbaren Polyimid härtbare Vorstufe, die zum Polyimid ausgehärtet wird.

28. Verfahren nach Anspruch 27, dadurch gekennzeichnet, daß man auf die freiliegende Fläche der Schicht aus formbarem Polyimid bei einer Temperatur im Bereich von 150 bis 500°C eine weitere Schicht aus einem Trägermaterial aufbringt.

29. Verfahren nach Anspruch 27, dadurch gekennzeichnet, daß man mindestens zwei der erhaltenen Schichtkörper bei einer Temperatur im Bereich von 150 bis 500°C miteinander verbindet, wobei die Verbindung der Schichtkörper jeweils an der freiliegenden Oberfläche des formbaren Polyimids erfolgt.

30. Verfahren nach Anspruch 29, dadurch gekennzeichnet, daß das Verbinden der Schichtkörper bei einer

Temperatur im Bereich von 250° C bis 400° C durchgeführt wird.

31. Verfahren nach den Ansprüchen 27 bis 30, dadurch gekennzeichnet, daß man das mit der Polyamidsäurelösung beschichtete Trägermaterial kontinuierlich durch mindestens zwei Heizzonen mit steigender Temperatur laufen läßt.

32. Verfahren nach den Ansprüchen 27 bis 31, dadurch gekennzeichnet, daß die Umsetzung der aromatischen Tetracarbonsäure oder ihres Dianhydrids mit dem aromatischen Diamin zur Polyamidsäurelösung in einem Extruder durchgeführt wird.

33. Verfahren nach den Ansprüchen 27 bis 32, dadurch gekennzeichnet, daß die Polyamidsäurelösung von einer Misch- und Fördervorrichtung kontinuierlich dosiert und durch eine geformte Öffnung auf das Trägermaterial extrudiert wird.

34. Verfahren nach den Ansprüchen 27 bis 32, dadurch gekennzeichnet, daß die Polyamidsäurelösung durch Rakeln auf das Trägermaterial aufgebracht wird.

35. Verfahren nach den Ansprüchen 27 bis 34, dadurch gekennzeichnet, daß der Film in der zweiten Stufe auf eine Temperatur im Bereich von 300 bis 600° C erhitzt wird.

36. Verfahren nach den Ansprüchen 27 bis 35, dadurch gekennzeichnet, daß das polare organische Lösungsmittel ein aprotisches Lösungsmittel ist.

37. Verfahren nach Anspruch 36, dadurch gekennzeichnet, daß das aprotische polare organische Lösungsmittel Dimethylacetamid, Dimethylformamid, N-Methyl-2-pyrrolidon und/oder Dimethylsulfoxid ist.

38. Verfahren nach den Ansprüchen 27 bis 37, dadurch gekennzeichnet, daß als Trägermaterial eine Folie aus Kupfer, Nickel, Aluminium, oder einer Legierung, welche eines oder mehrere dieser Metalle als wesentlichen Bestandteil enthält, oder eine Folie aus amorphem Metall oder eine Folie aus Stahl verwendet wird und die mit der Polyamidsäurelösung zu beschichtende Oberfläche des Trägermaterials vorher mittels mechanischer und/oder chemischer Behandlung aufgerauht bzw. geätzt wurde.

39. Verfahren nach Anspruch 38, dadurch gekennzeichnet, daß die chemische und/oder mechanische Vorbehandlung so durchgeführt wird, daß die zu beschichtende Oberfläche des Trägermaterials nach der Vorbehandlung einen Mittenrauhwert von mindestens 0,20 µm hat.

40. Verfahren nach den Ansprüchen 27 bis 39, dadurch gekennzeichnet, daß das heißsiegelbare Polyimid oder dessen Vorstufe auf die Schicht(en), die zu nicht mehr formbarem Polyimid führt (führen), zu Beginn der zweiten Aushärtestufe aufgebracht wird.

**Claims**

1. A flexible multilayer laminate consisting of at least one layer of a support material and at least one layer of a fully aromatic, no longer formable polyimide, at least one layer of no longer formable polyimide directly adhering on one side to a layer of support material with a peel strength of at least 4.0 N/cm, this no longer formable polyimide being insoluble in phenolic solvents and this layer of no longer formable polyimide having a tensile strength of 100 to 150 N/mm, an elongation at break of 15 to 100 % and a dissipation factor of $1.5 \times 10^{-3}$ to $5 \times 10^{-3}$ at 1 kHz, a layer of a heat-sealable polyimide, which does not melt below 200° C and can be formed at a temperature in the range from 150° C to 500° C, optionally under pressure, being situated on that side of the layer of no longer formable polyimide which is remote from the support material.

2. A laminate as claimed in claim 1, characterized in that a layer of a fully aromatic, no longer formable polyimide is also situated on the other side of the layer of heat- sealable polyimide, that side of this layer of no longer formable polyimide which is remote from the heat-sealable polyimide adhering directly to a layer of support material and the layers of of no longer formable polyimides in the laminate and/or the layers of support materials being the same or different.

3. A laminate as claimed in claims 1 and 2, characterized in that at least one layer of support material is directly joined on either side to a layer of no longer formable, fully aromatic polyimide.

4. A laminate as claimed in claims 1 to 3, characterized in that the bond between the no longer formable polyimide and the heat-sealable polyimide is established by mutual penetration of these materials in one another.

5. A laminate as claimed in claims 1 to 4, characterized in that the combined layer of no longer formable polyimide and heat-sealable polyimide has a tensile strength of 100 to 150 $N/mm^2$, an elongalion at break of 15 to 100 % and a dissipation factor of $1.5 \times 10^{-3}$ to $5 \times 10^{-3}$ at 1 kHz.

6. A laminate as claimed in claims 1 to 5, characterized in that the thickness of each layer of no longer formable polyimide is from 1 µm to 1 mm.

7. A laminate as claimed in claim 6, characterized in that the layer thickness is from 1 µm to 15 µm.

8. A laminale as claimed in claim 6, characterized in that the thickness of each layer of no longer formable polyimide is from 10 µm to 1 mm.

9. A laminate as claimed in claim 8, characterized in that the thickness of each layer of no longer formable polyimide is from 50 to 250 µm.

10. A laminate as claimed in claims 1 to 9, characterized in that the thickness of the layer of heat-sealable polyimide is from 0.5 to 3 µm.

11. A laminate as claimed in claims 1 to 9, characterized in that the thickness of the layer of heat-sealable

polyimide is from 2 to 50 µm.

12. A laminate as claimed in claims 2 to 11, characterized in that all the layers of no longer formable polyimide have the same thickness.

13. A laminate as claimed in claims 1 to 12, characterized in that the layer(s) of no longer formable polyimide consist(s) of a polyimide having the following recurring structure

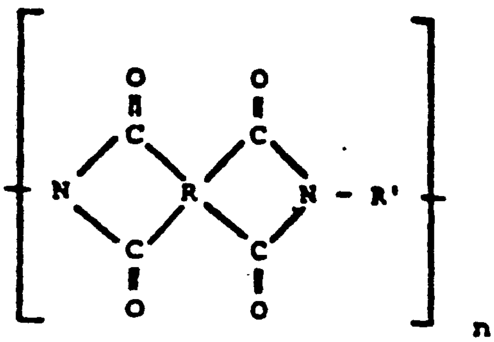

in which

R is a tetrafunctional aromatic radical,

R' is a difunctional aromatic radical.

14. A laminate as claimed in claim 13, characterized in that

R = 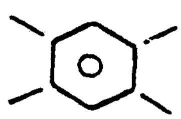 and R' = 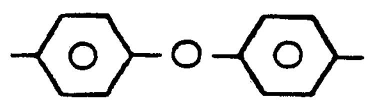

15. A laminate as claimed in claims 1 to 14, characterized in that the layer or layers of support material independently of one another consist of a foil of a metal or metal alloy or of a polymer film or of a fabric of a fibrous material.

16. A laminate as claimed in claim 15, characterized in that the support material is a foil of copper, nickel, aluminium or of an alloy containing one or more of the metals as its principal constituent or a foil of amorphous metal or a foil of steel.

17. A laminate as claimed in claim 16, characterized in that the foil consists of rolled, tempered copper or a rolled and tempered copper alloy.

18. A laminate as claimed in claim 16 or 17, characterized in that the layer thickness of the foil is from 5 to 250 µm.

19. A laminate as claimed in claim 18, characterized in that the layer thickness of the foil is from 10 to 50 µm.

20. A laminate as claimed in claims 1 to 19, characterized in that the heat-sealable polyimide is the reaction product of benzophenone tetracarboxylic acid dianhydride (BTDA) or of a mixture of BTDA and pyromellitic dianhydride with 4,4'-diaminodiphenylether, 3,3'-diaminodiphenylether, 3,3'-diaminodiphenylsulphone, 3,3'-diaminodiphenylmethane, 4,4'-diaminodiphenylsulphone, 4,4'-diaminodiphenylmethane, benzidine or with mixtures of these diamines.

21. A laminate as claimed in claims 1 to 19, characterized in that the heat-sealable polyimide is the reaction product of a dianhydride with a diamine, the dianhydride having the following formula

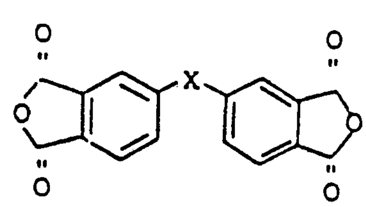

in which X is an oxygen atom or a $C_nF_{2n}$ group with n = 1 to 10 or the group

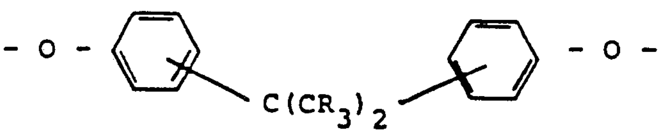

in which R is a hydrogen atom or a fluorine atom and in which the $(CR_3)_2$ group is in the meta or para position to the particular oxygen atom,

and the diamine having the following formula

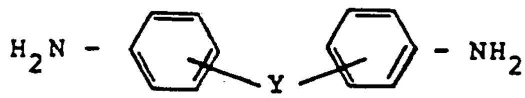

or the following formula

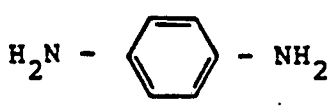

in which Y is an oxygen atom or a $C_nF_{2n}$ group with $n = 1$ to 10 or a carbonyl group and is in the meta or para position to the particular amino group.

22. A laminate as claimed in claims 1 to 21, characterized in that the layer of heat-sealable polyimide contains a fibrous material.

23. A laminate as claimed in claim 22, characterized in that the fibrous material consists of glass fibres, aramide fibres, carbon fibres and/or silica fibres.

24. A laminate as claimed in claim 22 or 23, characterized in that the fibrous material is a woven fabric of endless filaments.

25. A laminate as claimed in claims 2 to 24, characterized in that the layers of no longer formable polyimides are joined to one another by two layers of heat-sealable polyimide.

26. A laminate as claimed in claims 1 and 3 to 24, characterized in that a layer of support material is situated on the layer of heat-sealable polyimide on that side remote from the no longer formable polyimide.

27. A process for the production of the laminates claimed in claims 1 to 26 comprising the following steps: a polyamide acid solution is formed from an aromatic tetracarboxylic acid or its dianhydride and a primary aromatic diamine by reaction of the aromatic tetracarboxylic acid or its dianhydride with the aromatic diamine in a molar ratio of 0.95 : 1 to 1.05 : 1 in a polar organic solvent to form a polymer compound of a polyamide acid corresponding to the following formula

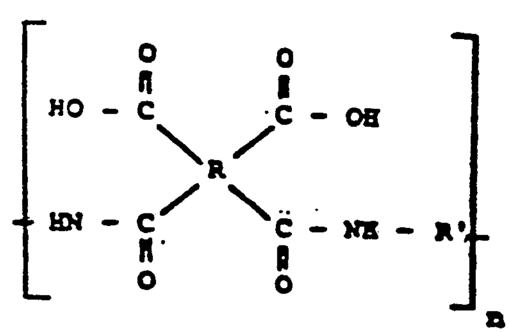

in which

R is an aromatic tetrafunctional radical and

R' is a difunctional aromatic radical and the value of n is sufficient to obtain a polyamide acid having an $\eta_{red}$ value of at least 0.5; the polyamide acid solution is applied without any intermediate layer to a support material and the solvent is removed in situ in a first step carried out at a temperature of 100 to 200°C, substantially all the solvent being removed; in a second step carried out at a temperature of more than 200°C and preferably more than 300°C, the film is hardened in situ to form a no longer formable polyimide insoluble in phenolic solvents, at least 95 % of the polyamide acid being reacted to polyimide; a layer of a polyimide formable at a temperature of 150 to 500°C is applied to that side of the layer of no longer formable polyimide which is remole from the support material or an intermediale stage hardenable to such a formable polyimide is hardened to form the polyimide.

28. A process as claimed in claim 27, characterized in that another layer of a support material is applied at a

temperature of 150 to 500° C to the exposed surface of the layer of formable polyimide.

29. A process as claimed in claim 27, characterized in that at least two of the layer combinations obtained are joined to one another at a temperature of 150 to 500° C, the layer combinations each being joined to the other on the exposed surface of the formable polyimide.

30. A process as claimed in claim 29, characterized in that the layer combinations are joined at a temperature of 250 to 400° C.

31. A process as claimed in claims 27 to 30, characterized in that the support material coated with the polyamide acid solution is allowed to pass continuously through at least two heating zones with increasing temperature.

32. A process as claimed in claims 27 to 31, characterized in that the reaction of the aromatic tetracarboxylic acid or its dianhydride with the aromatic diamine to form the polyamide acid solution is carried out in an extruder.

33. A process as claimed in claims 27 to 32, characterized in that the polyamide acid solution is continuously dosed by a mixing and transporting unit and extruded through a shaped opening onto the support material.

34. A process as claimed in claims 27 to 32, characterized in that the polyamide acid solution is applied to the support material by knife coating.

35. A process as claimed in claims 27 to 34, characterized in that, in the second step, the film is heated to a temperature in the range from 300 to 600° C.

36. A process as claimed in claims 27 to 35, characterized in that the polar organic solvent is an aprotic solvent.

37. A process as claimed in claim 36, characterized in that the aprotic polar organic solvent is dimethyl acelamide, dimethyl formamide, N-melhyl-2-pyrrolidone and/or dimethyl formamide.

38. A process as claimed in claims 27 to 37, characterized in that the support material used is a foil of copper, nickel, aluminium or of an alloy containing one or more of these metals as its principal constituent or a foil of an amorphous metal or a foil of steel and the surface of the support material to be coated wilh the polyamide acid solution was roughened or etched beforehand by mechanical and/or chemical treatment.

39. A process as claimed in claim 38, characterized in that the chemical and/or mechanical pretreatment is carried out in such a way that, after the pretreatment, the surface of the support material to be coated has a centre line average of at least 0.20 µm.

40. A process as claimed in claims 27 to 39, characterized in that the heat-sealable polyimide or its intermediate stage is applied to the layer(s) leading to no longer formable polyimide at the beginning of the second hardening step.

**Revendications**

1. Stratifié multicouche flexible, constitué d'au moins une couche d'un matériau de support et au moins une couche à base d'un polyimide purement aromatique désormais non plastique, au moins une couche à base de polyimide désormais non plastique adhérant d'un côté, avec une résistance à l'arrachage d'au moins 4,0 N/cm, directement à une couche de matériau de support, ce polyimide désormais non plastique étant insoluble dans des solvants phénoliques et cette couche à base de polyimide désormais non plastique présentant une résistance à la traction de 100 à 150 N/mm$^2$, un allongement à la rupture de 15 - 100 % et un facteur de pertes diélectriques allant, à 1 kHz, de 1,5 x $10^{-3}$ a 5 x $10^{-3}$, et sur le côté opposé au matériau de support de cette couche à base de polyimide désormais non plastique, se trouvant une couche d'un polyimide soudable à chaud qui ne fond pas à moins de 200°C et qui est plastique à une température comprise entre 150 et 500°C, éventuellement par application d'une pression.

2. Stratifié selon la revendication 1, caractérisé par le fait que sur l'autre côté de la couche de polyimide soudable à chaud se trouve une couche à base d'un polyimide purement aromatique désormais non plastique, le côté opposé au polyimide soudable à chaud de cette couche à base de polyimide désormais non plastique adhérant directement à une couche de matériau de support, et les couches à base de polyimides désormais non plastiques et/ou les couches de matériaux de support contenues dans le stratifié étant respectivement identiques ou différentes.

3. Stratifié selon les revendications 1 et 2, caractérisé par le fait qu'au moins une couche de matériau de support est directement liée de chaque côté à une couche à base de polyimide purement aromatique désormais non plastique.

4. Stratifié selon les revendications 1 à 3, caractérisé par le fait que la liaison entre polyimide désormais non plastique et polyimide soudable à chaud est effectuée par pénétration mutuelle de ces matériaux l'un dans l'autre.

5. Stratifié selon les revendications 1 à 4, caractérisé par le fait que l'assemblage de couches qui est constitué de polyimide désormais non plastique et de polyimide soudable à chaud présente une résistance à la traction de 100 à 150 N/mm$^2$, un allongement à la rupture de 15 à 100 % et un facteur de pertes diélectriques allant, à 1 kHz, de 1,5 x $10^{-3}$ à 5 x $10^{-3}$.

6. Stratifié selon les revendications 1 à 5, caractérisé par le fait que l'épaisseur de chaque couche à base de polyimide désormais non plastique est de 1 µm à 1 mm.

7. Stratifié selon la revendication 6, caractérisé par le fait que l'épaisseur de couche est de 1 µm à 15 µm.

8. Stratifié selon la revendication 6, caractérisé par le fait que l'épaisseur de chaque couche à base de polyimide désormais non plastique est de 10 µm à 1 mm.

9. Stratifié selon la revendication 6, caractérisé par le fait que l'épaisseur de chaque couche à base de polyimide désormais non plastique est de 50 à 250 µm.

10. Stratifié selon les revendications 1 à 9, caractérisé par le fait que l'épaisseur de la couche de polyimide soudable à chaud est de 0,5 à 3 µm.

11. Stratifié selon les revendications 1 à 9, caractérisé par le fait que l'épaisseur de la couche de polyimide soudable à chaud est de 2 à 50 µm.

12. Stratifié selon les revendications 2 à 11, caractérisé par le fait que toutes les couches à base de polyimide désormais non plastique ont la même épaisseur.

13. Stratifié selon la revendication 1 à 12, caractérisé par le fait que la couche ou les couches à base de polyimide non plastique est(sont) constituée(s) d'un polyimide qui comporte le motif répétitif suivant

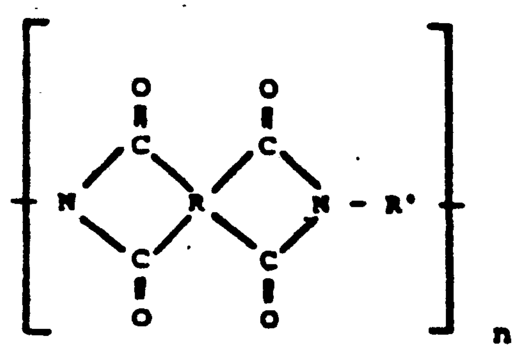

dans lequel

R est un radical aromatique tétravalent,

R' est un radical aromatique bivalent.

14. Stratifié selon la revendication 13, caractérisé par le fait que

R représente

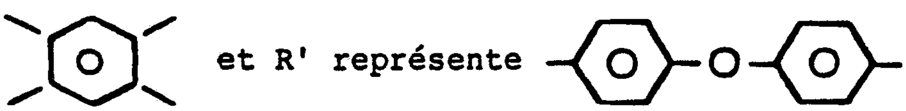

et R' représente

15. Stratifié selon les revendications 1 à 14, caractérisé par le fait que la couche ou les couches de matériau de support consistent chacune, indépendamment les unes des autres, en une feuille de métal ou d'un alliage de métaux, ou en une feuille de polymère ou en une nappe d'un matériau fibreux.

16. Stratifié selon la revendication 15, caractérisé par le fait que le matériau de support est une feuille de cuivre, nickel, aluminium ou d'un alliage contenant un ou plusieurs de ces métaux en tant que composant(s) essentiel(s), ou une feuille de métal amorphe ou une feuille d'acier.

17. Stratifié selon la revendication 6, caractérisé par le fait que la feuille est constituée de cuivre recuit laminé ou d'un alliage de cuivre recuit laminé.

18. Stratifié selon les revendications 16 ou 17, caractérisé par le fait que l'épaisseur de couche de la feuille est de 5 à 250 µm.

19. Stratifié selon la revendication 18, caractérisé par le fait que l'épaisseur de couche de la feuille est de 10 à 50 µm.

20. Stratifié selon les revendications 1 à 19, caractérisé par le fait que le polyimide soudable à chaud est le produit de réaction du dianhydride benzophénonetétracarboxylique (BDTA), ou d'un mélange de BDTA et de dianhydride pyromellitique, avec l'éther 4,4'-diaminodiphénylique, l'éther 3,3'-diaminodiphénylique, la 3,3'-diaminodiphénylsulfone, le 3,3'-diaminodiphénylméthane, la 4,4'-diaminodiphénylsulfone, le 4,4'-diaminodiphénylméthane, la benzidine, ou avec des mélanges de ces diamines.

21. Stratifié selon les revendications 1 à 19, caractérisé par le fait que le polyimide soudable à chaud est le produit de réaction d'un dianhydride avec une diamine, le dianhydride correspondant à la formule

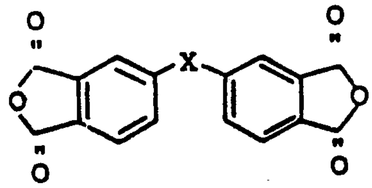

dans laquelle X représente un atome d'oxygène ou représente un groupe $C_nF_{2n}$ avec n = 1 à 10, ou le groupement

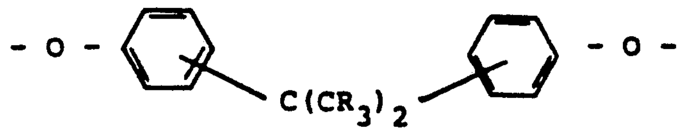

dans lequel R représente un atome d'hydrogène ou un atome de fluor, et dans lequel le groupe $(CR_3)_2$ se trouve chaque fois en position méta ou para par rapport à l'atome d'oxygène concerné, et la diamine correspondant à la formule

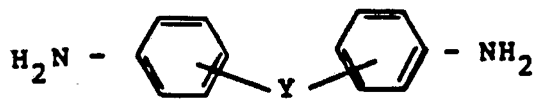

ou à la formule

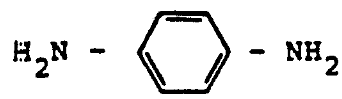

Y représentant un atome d'oxygène ou un groupe $C_nF_{2n}$ avec n = 1 à 10, ou un groupe carbonyle, et Y se trouvant chaque fois en position méta ou para par rapport au groupe amino concerné.

22. Stratifié selon les revendications 1 à 21, caractérisé par le fait que la couche à base de polyimide soudable à chaud contient un matériau fibreux.

23. Stratifié selon la revendication 22, caractérisé par le fait que le matériau fibreux est à base de fibre de verre, fibre aramide, fibre de carbone et/ou fibre de silice.

24. Stratifié selon la revendication 22 ou 23, caractérisé par le fait que le matériau fibreux est un tissu de filaments continus.

25. Stratifié selon les revendications 2 à 24, caractérisé par le fait que les couches à base de polyimides désormais non plastiques sont liées entre elles par deux couches de polyimide soudable à chaud.

26. Stratifié selon les revendications 1 et 3 à 24, caractérisé par le fait qu'une couche de matériau de support se trouve sur la couche de polyimide soudable à chaud, du côté opposé au polyimide désormais non plastique.

27. Procédé pour la fabrication de stratifiés selon les revendications 1 à 26, lequel comporte les étapes suivantes: on prépare une solution de polyamide-acide à partir d'un acide tétracarboxylique aromatique, ou de son dianhydride, et d'une diamine primaire aromatique, en faisant réagir dans un solvant organique polaire l'acide tétracarboxylique aromatique, ou son dianhydride, avec la diamine aromatique dans le rapport molaire de 0,95 : 1 à 1,05 : 1, pour aboutir à un composé polymère constitué d'un polyamide-acide de formule

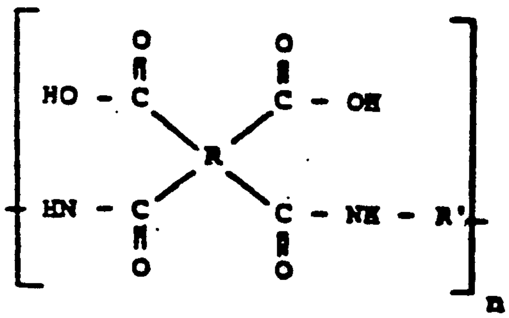

dans laquelle

R représente un radical aromatique tétravalent et

R' représente un radical aromatique bivalent, et

n est suffisant pour l'obtention d'un polyamide-acide ayant une viscosité réduite $\eta_{red}$ d'au moins 0,5; on applique sur un matériau de support, sans couche imtermédiaire, la solution de polyamide-acide obtenue, et on élimine in situ le solvant dans une première étape effectuée à une température dans la plage de 100 à 200°C, ce par quoi pratiquement la quantité totale du solvant est éliminée; on durcit le film in situ dans une seconde étape dans laquelle la température est supérieure à 200°C, de préférence supérieure à 300°C, pour aboutir à un polyimide désormais non plastique, insoluble dans des solvants phénoliques, au moins 95 % du polyamide-acide étant transformés en polyimide; on applique sur le côté opposé au matériau de support de la couche à base de polyimide, désormais non plastique, une couche d'un polyimide plastique à une température comprise entre 150 et 500°C, ou un précurseur durcissable en un polyimide plastique de ce type, qu'on durcit pour aboutir au polyimide.

28. Procédé selon la revendication 27, caractérisé par le fait que sur la face découverte de la couche à base de polyimide plastique, on applique, à une température dans la plage de 150 à 500°C, une autre couche d'un matériau de support.

29. Procédé selon la revendication 27, caractérisé par le fait qu'on assemble l'un avec l'autre, à une température dans la plage de 150 à 500°C, au moins deux des corps stratifiés obtenus, la liaison des corps stratifiés étant effectuée par chacune des surfaces découvertes du polyimide plastique.

30. Procédé selon la revendication 29, caractérisé par le fait qu'on effectue la liaison des corps stratifiés à une température dans la plage de 250 à 400°C.

31. Procédé selon les revendications 27 à 30, caractérisé par le fait qu'on fait passer en continu le matériau de support, revêtu avec la solution de polyamide-acide, à travers au moins deux zones de chauffe à température croissante.

32. Procédé selon les revendications 27 à 31, caractérisé par le fait qu'on effecture dans une extrudeuse la réaction de l'acide tétracarboxylique aromatique ou de son dianhydride avec la diamine aromatique, pour l'obtention de la solution de polyamide-acide.

33. Procédé selon les revendications 27 à 32, caractérisé par le fait que la solution de polyamide-acide est ajoutée en continu, de façon réglée, par un dispositif de mélangeage et alimentation, puis extrudée sur le matériau de support par un orifice ayant une forme définie.

34. Procédé selon les revendications 27 à 32, caractérisé par le fait qu'on applique à l'aide d'une racle la solution de polyamide-acide sur le matériau de support.

35. Procédé selon les revendications 27 à 34, caractérisé par le fait que dans la seconde étape on chauffe le film à une température dans la plage de 300 à 600°C.

36. Procédé selon les revendications 27 à 35, caractérisé par le fait que le solvant organique polaire est un solvant aprotique.

37. Procédé selon la revendication 36, caractérisé par le fait que le solvant organique aprotique polaire est le diméthylacétamide, le diméthylformamide, la N-méthyl-2-pyrrolidone et/ou le diméthylsulfoxyde.

38. Procédé selon les revendications 27 à 37, caractérisé par le fait qu'on utilise en tant que matériau de support une feuille de cuivre, nickel, aluminium ou d'un alliage qui contient un ou plusieurs de ces métaux en tant que composant(s) essentiel(s), ou une feuille de métal amorphe ou une feuille d'acier, et la surface du matériau de support à revêtir avec la solution de polyamide-acide a été préalablement grainée ou attaquée au moyen d'un traitement mécanique et/ou chimique.

39. Procédé selon la revendication 36, caractérisé par le fait qu'on effectue le prétraitement chimique et/ou mécanique de manière qu'après le prétraitement, la surface à enduire du matériau de support ait une rugosité moyenne d'au moins 0,20 µm.

40. Procédé selon les revendications 27 à 39, caractérisé par le fait qu'au début de la seconde étape de durcissement, on applique le polyimide soudable à chaud, ou son précurseur, sur la(les) couche(s) conduisant au polyimide désormais non plastique.

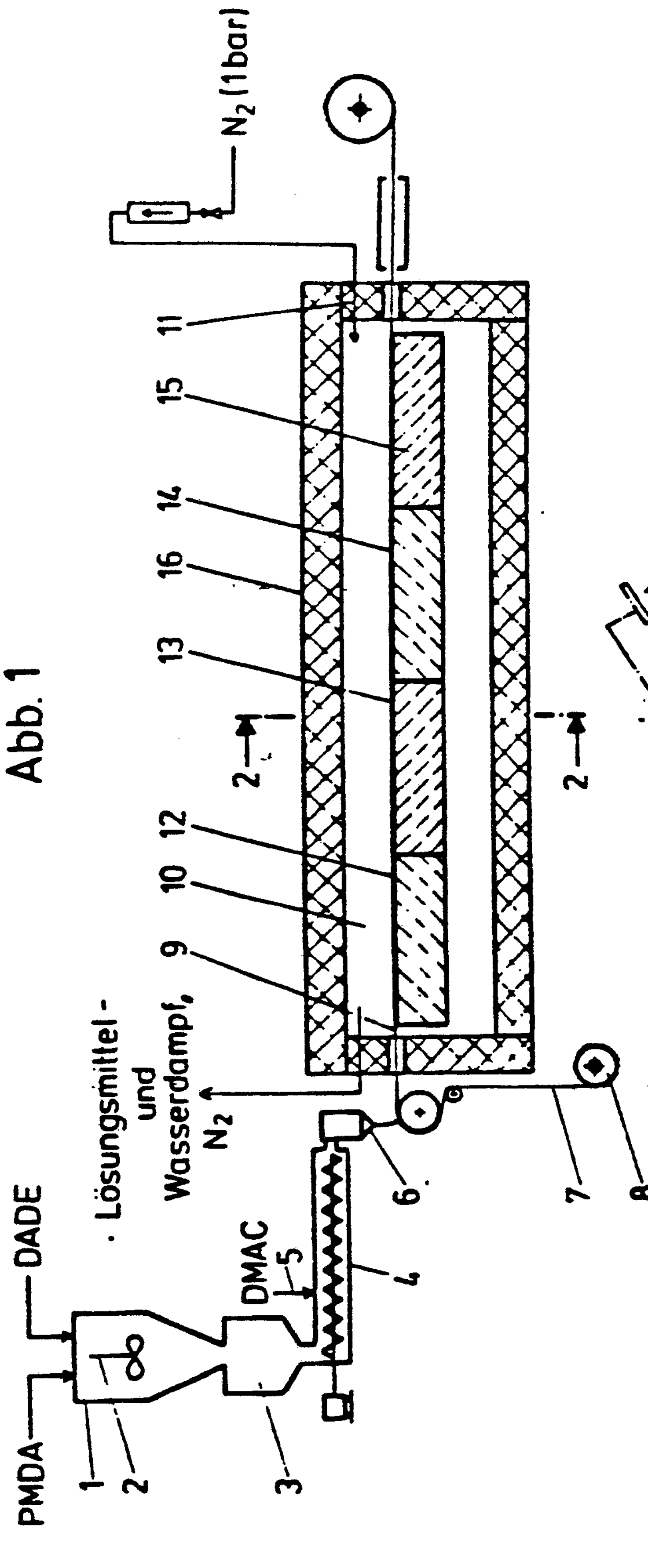
PMDA
DADE
DMAC
Lösungsmittel-
und
Wasserdampf,
$N_2$
$N_2$ (1bar)
1
2
3
4
5
6
7
8
9
10
11
12
13
14
15
16
2
2

Abb. 1

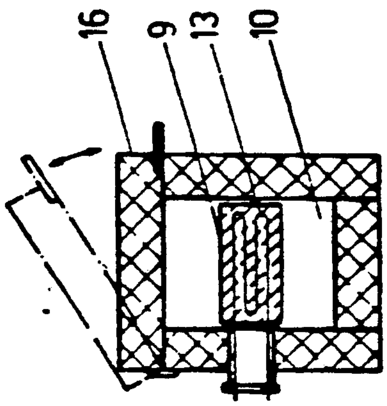
16
9
13
10

Abb. 2